# EUROPEAN PATENT APPLICATION

(11) **EP 4 580 368 A2**
(43) Date of publication of application: **02.07.2025**
(21) Application number: 24206136.4
(22) Date of filing: 11.10.2024
(51) Int. Cl.: H10K 59/124, H10K 59/38, H10K 59/80, H10K 50/19

(54) **DISPLAY DEVICE**

(30) Priority: 27.12.2023 KR 20230192986
(71) Applicant: LG Display Co., Ltd., Seoul 07336 (KR)
(72) Inventor: KIM, Seungkyeom, 10845 Paju-si, Gyeonggi-do (KR)
(74) Representative: Viering, Jentschura & Partner mbB Patent- und Rechtsanwälte

(57) **Abstract**

A display device (100) includes a circuit element layer (20) on a substrate (10); a first passivation layer (30) covering the circuit element layer (20); a first overcoat layer (50) on the first passivation layer (30); a second passivation layer (60) on the first overcoat layer (50), the second passivation layer (60) having a first trench (T11) through the second passivation layer (60) at a portion between two neighboring light emitting areas (EA), wherein the second passivation layer (60) includes a first sloped surface (60S) exposed by the first trench (T11); a second overcoat layer (70) on the second passivation layer (60), the second overcoat layer (70) having a second trench (T21) defined by a second sloped surface (70S) of the second overcoat layer (70), and the second trench (T21) exposing the first trench (T11); a first electrode (81) on the second overcoat layer (70), and exposing the first and second trenches (T11, T21); an organic layer (82) on the first electrode (81), the first sloped surface (60S), and the second sloped surface (70S); and a second electrode (83) on the organic layer (82).

## Description

### CROSS-REFERENCE TO RELATED APPLICATION

This application claims priority from Korean Patent Application No. 10-2023-0192986 filed on December 27, 2023.

### BACKGROUND

### TECHNICAL FIELD

Embodiments of the present disclosure relate to a display device.

### DISCUSSION OF THE RELATED ART

As the information society develops, demands for display devices for displaying an image are increasing in various forms. Accordingly, recently, various display devices such as a liquid crystal display device (LCD), an inorganic light emitting display device and an organic light emitting display device (OLED) have been used.

Among display devices, an organic light emitting display device as a self-emissive type provides advantages in that it has a superior viewing angle and contrast ratio compared to a liquid crystal display device (LCD) and does not require a separate backlight to be lightweight and thin and be advantageous in terms of power consumption. In addition, the organic light emitting display device provides advantages in that it is capable of being driven at a low direct current voltage and has a fast response speed and especially a low manufacturing cost.

### SUMMARY

Accordingly, embodiments of the present disclosure are directed to a display device that substantially obviates one or more of the problems due to limitations and disadvantages of the related art.

An aspect of the present disclosure is to provide a display device that can improve light extraction efficiency and suppress side leakage current.

Another aspect of the present disclosure is to provide a display device that can suppress side leakage current to prevent an unintended subpixel from emitting light and can improve color gamut and display quality at a low grayscale.

Additional features and aspects will be set forth in the description that follows, and in part will be apparent from the description, or may be learned by practice of the inventive concepts provided herein. Other features and aspects of the inventive concepts may be realized and attained by the structure particularly pointed out in the written description, or derivable therefrom, and the claims hereof as well as the appended drawings.

To achieve these and other aspects of the inventive concepts, as embodied and broadly described herein, a display device according to claim 1, a display device according to claim 7, and a display device according to claim 12 are provided. Further embodiments are described in the dependent claims. In as aspect, a display device, including a plurality of light emitting areas corresponding to a plurality of subpixels, comprises: a substrate; a circuit element layer on the substrate; a first passivation layer covering the circuit element layer; a first overcoat layer on the first passivation layer; a second passivation layer on the first overcoat layer, the second passivation layer having a first trench through the second passivation layer at a portion between two neighboring light emitting areas among the plurality of light emitting areas, wherein the second passivation layer includes a first sloped surface exposed by the first trench; a second overcoat layer on the second passivation layer, the second overcoat layer having a second trench defined by a second sloped surface of the second overcoat layer adjacent to the first trench, and the second trench exposing the first trench; a first electrode on the second overcoat layer, and exposing the first and second trenches; an organic layer on the first electrode, the first sloped surface, and the second sloped surface; and a second electrode on the organic layer.

In another aspect, a display device, including a plurality of light emitting areas corresponding to a plurality of subpixels, comprises: a substrate; a circuit element layer on the substrate; a first passivation layer on the circuit element layer; a first overcoat layer on the first passivation layer; a second overcoat layer on the first overcoat layer, the second overcoat layer having a first trench through the second overcoat layer at a portion between two neighboring light emitting areas among the plurality of light emitting areas, wherein the second overcoat layer includes a first sloped surface exposed by the first trench; a second passivation layer on the second overcoat layer, the second passivation layer having a second trench defined by a second sloped surface of the second passivation layer adjacent to the first trench, and the second trench exposing the first trench; a first electrode on the second passivation layer, and exposing the first and second trenches; an organic layer on the first electrode, the first sloped surface, and the second sloped surface; and a second electrode on the organic layer.

In another aspect, a display device, including a plurality of light emitting areas corresponding to a plurality of subpixels, comprises: a substrate; a circuit element layer on the substrate; a first passivation layer on the circuit element layer; a color filter layer on the first passivation layer; a second passivation layer covering the color filter layer; an overcoat layer on the second passivation layer, the overcoat layer having first trench with a first sloped surface of the overcoat layer at a portion between two neighboring light emitting areas among the plurality of light emitting areas; a first electrode on the overcoat layer and exposing the first trench; an organic layer on the first electrode and the first sloped surface; and a second electrode on the organic layer.

In another aspect, a display device comprises a display panel including an active area having a plurality of light emitting areas corresponding to a plurality of subpixels, and a non-active area surrounding the active area, the display panel comprising: a substrate; a circuit element layer on the substrate; a first passivation layer on the circuit element layer; a color filter layer on the first passivation layer; a second passivation layer covering the color filter layer; an overcoat layer on the second passivation layer, the overcoat layer having a first trench with a first sloped surface of the overcoat layer at a portion between two neighboring light emitting areas among the plurality of light emitting areas; a first electrode on the overcoat layer and exposing the first trench; an organic layer on the first electrode and the first sloped surface; and a second electrode on the organic layer.

According to the embodiments of the present disclosure, a display device may be provided that improves light extraction efficiency and suppresses side leakage current.

According to the embodiments of the present disclosure, a display device may be provided that can suppress side leakage current to minimize light emission of an unintended subpixel to improve color gamut and which can minimize the visual recognition of spots or color abnormalities when displaying an image of a low grayscale, to improve display quality.

According to the embodiments of the present disclosure, a display device may be provided that can improve light extraction efficiency to increase the amount of light emitted from the display device to increase luminance, to emit a sufficient amount of light at a low voltage to reduce power consumption, and to improve light efficiency to increase a viewing angle and luminance to provide a wide viewing angle.

According to the embodiments of the present disclosure, a display device may be provided that can suppress penetration of oxygen from the outside to prevent defects due to oxygen penetration and improve reliability.

According to the embodiments of the present disclosure, a display device may be provided that can be manufactured at low cost by reducing the number of masks to be used.

It is to be understood that both the foregoing general description and the following detailed description are exemplary and explanatory and are intended to provide further explanation of the inventive concepts as claimed.

### BRIEF DESCRIPTION OF DRAWINGS

The accompanying drawings, which are included to provide a further understanding of the disclosure and are incorporated in and constitute a part of this application, illustrate embodiments of the disclosure and together with the description serve to explain various principle.
FIG. 1 is a diagram showing the schematic system configuration of a display device according to embodiments of the present disclosure.
FIG. 2 is a plan view schematically showing pixels disposed in the display panel of a display device according to embodiments of the present disclosure.
FIG. 3 is a view showing an example of a cross-section taken along the line I-I' of FIG. 2.
FIG. 4 is an enlarged view of the part A of FIG. 3.
FIG. 5 is of views showing changes in the profile of an organic layer depending on a change in the slope angle of the side surface of a trench under the organic layer.
FIG. 6 is of views showing changes in the profile of an organic layer depending on a change in the depth of a trench under the organic layer.
FIGs. 7A to 7E are cross-sectional views showing a method of manufacturing the display panel of a display device according to embodiments of the present disclosure.
FIG. 8 is a view showing an example of a cross-section of the display panel of a display device according to embodiments of the present disclosure.
FIGs. 9A to 9E are cross-sectional views showing a method of manufacturing the display panel of a display device according to embodiments of the present disclosure.
FIGs. 10 to 12 are views showing examples of cross-sections of the display panel of a display device according to embodiments of the present disclosure.
FIGs. 13A to 13E are cross-sectional views showing a method of manufacturing the display panel of a display device according to embodiments of the present disclosure.
FIG. 14 is a view showing an example of a cross-section of the display panel of a display device according to embodiments of the present disclosure.

### DETAILED DESCRIPTION

In the following description of examples or embodiments of the present disclosure, reference will be made to the accompanying drawings in which it is shown by way of illustration specific examples or embodiments that can be implemented, and in which the same reference numerals and signs can be used to designate the same or like components even when they are shown in different accompanying drawings from one another. Further, in the following description of examples or embodiments of the present disclosure, detailed descriptions of well-known functions and components incorporated herein will be omitted when it is determined that the description may make the subject matter in some embodiments of the present disclosure rather unclear. The terms such as "including," "having," "containing," "constituting," "make up of' and "formed of" used herein are generally intended to allow other components to be added unless the terms are used with the term "only." As used herein, singular forms are intended to include plural forms unless the context clearly indicates otherwise.

Terms, such as "first," "second," "A," "B," "(A)" or "(B)" may be used herein to describe elements of the present disclosure. Each of these terms is not used to define essence, order, sequence, number of elements, etc., but is used merely to distinguish the corresponding element from other elements.

When it is mentioned that a first element "is connected or coupled to," "contacts or overlaps," etc. a second element, it should be interpreted that, not only can the first element "be directly connected or coupled to" or "directly contact or overlap" the second element, but a third element can also be "interposed" between the first and second elements, or the first and second elements can "be connected or coupled to," "contact or overlap," etc. each other via a fourth element. Here, the second element may be included in at least one of two or more elements that "are connected or coupled to," "contact or overlap," etc. each other.

When time relative terms, such as "after," "subsequent to," "next," "before," and the like, are used to describe processes or operations of elements or configurations, or flows or steps in operating, processing, manufacturing methods, these terms may be used to describe nonconsecutive or non-sequential processes or operations unless the term "directly" or "immediately" is used together.

In addition, when any dimensions, relative sizes, etc. are mentioned, it should be considered that numerical values for elements or features, or corresponding information (e.g., level, range, etc.) include a tolerance or error range that may be caused by various factors (e.g., process factors, internal or external impact, noise, etc.) even when a relevant description is not specified. Further, the term "may" fully encompasses all the meanings of the term "can."

Hereinafter, various embodiments of the present disclosure will be described in detail with reference to accompanying drawings.

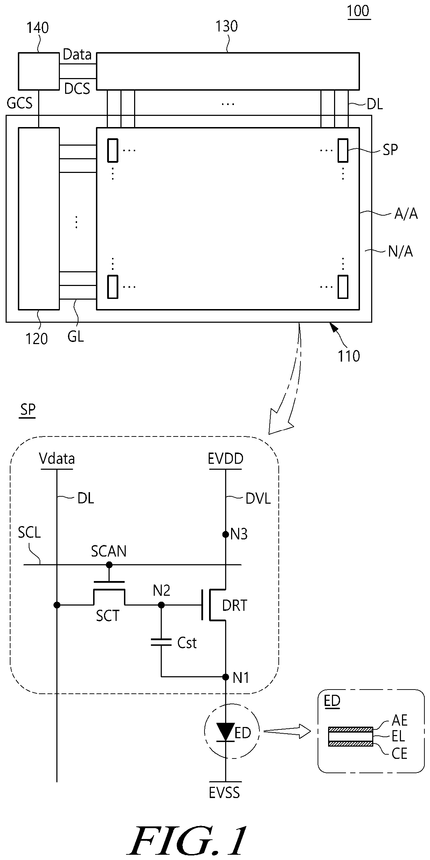

FIG. 1 is a diagram showing the schematic system configuration of a display device according to embodiments of the present disclosure.

With reference to FIG. 1, a display device 100 according to embodiments of the present disclosure includes a display panel 110. In addition, the display device 100 includes a driving circuit for driving various signal lines and so on disposed in the display panel 110. The driving circuit may include a gate driving circuit 120, a data driving circuit 130 and a controller 140.

The display panel 110 includes an active area A/A and a non-active area N/A outside the active area A/A. A plurality of subpixels SP are disposed in the active area A/A of the display panel 110. A plurality of gate lines GL that extend in a first direction (e.g., a column direction or a row direction) and a plurality of data lines DL that extend in a second direction intersecting the first direction are disposed in the display panel 110, and the subpixels SP may be disposed in areas where the gate lines GL and the data lines DL intersect each other.

The gate driving circuit 120 may generate gate signals and output the gate signals to the plurality of gate lines GL. As shown in FIG. 1, the gate driving circuit 120 may be disposed in the non-active area N/A of the display panel 110. For example, the display device 100 may be a gate-in-panel (GIP) type.

Although not shown, the gate driving circuit 120 may be formed separately from the display panel 110, and may be connected to the display panel 110 in a tape automated bonding (TAB) method, may be connected to the bonding pads of the display panel 110 in a chip-on-glass (COG) or chip-on-panel (COP) method or may be connected to the display panel 110 by being implemented in a chip-on-film (COF) method.

The data driving circuit 130 may output data signals (also referred to as "data voltages") corresponding to image signals to the plurality of data lines DL. The data driving circuit 130 may include at least one source driver integrated circuit. For example, each source driver integrated circuit may be connected to the display panel 110 in a tape automated bonding (TAB) method, may be connected to the bonding pads of the display panel 110 in a COG or COP method or may be connected to the display panel 110 by being implemented in a COF method.

In FIG. 1, the data driving circuit 130 is shown as a separate component from the display panel 110, but the data driving circuit 130 may be configured in an in-panel method to be formed integrally with the display panel 110. The data driving circuit 130 may be disposed in the non-active area N/A of the display panel 110.

The controller 140 may convert input image data inputted from an external host (not shown) to suit a data signal format used in the data driving circuit 130, and may supply the converted image data to the data driving circuit 130.

The subpixel SP may include a light emitting element ED and a pixel driving circuit for driving the same. The pixel driving circuit may include a driving transistor DRT, a scan transistor SCT and a storage capacitor Cst.

The light emitting element ED may be, for example, an organic light emitting diode (OLED), an inorganic-based light emitting diode (LED) or a quantum dot light emitting element that is a semiconductor crystal that emits light on its own.

When the display device 100 according to the embodiments of the present disclosure is an OLED display, each subpixel SP may include, as a light emitting element, an organic light emitting diode (OLED) that emits light on its own. When the display device 100 according to the embodiments of the present disclosure is a quantum dot display, each subpixel SP may include a light emitting element made of a quantum dot that is a semiconductor crystal that emits light on its own. When the display device 100 according to the embodiments of the present disclosure is a micro LED display, each subpixel SP may include, as a light emitting element, a micro light emitting diode (micro LED) that emits light on its own and is made on the basis of an inorganic material.

The driving transistor DRT as a transistor for driving the light emitting element ED by controlling current flowing to the light emitting element ED may have a first node N1, a second node N2 and a third node N3. The first node N1 may be a source or drain node, and may be electrically connected to an anode electrode AE of the light emitting element ED. The second node N2 may be a gate node, and may be electrically connected to a source or drain node of the scan transistor SCT. The third node N3 may be a drain or source node, and may be connected to a driving voltage line DVL that supplies a driving voltage EVDD.

The scan transistor SCT may control the connection between a data line DL and the second node N2 of the driving transistor DRT. In response to a scan signal SCAN supplied to a scan line SCL as a type of gate line GL, the scan transistor SCT may connect the second node N2 of the driving transistor DRT and a corresponding data line DL among the plurality of data lines DL. The scan transistor SCT may transfer a data voltage Vdata to the second node N2, that is the gate node of the driving transistor DRT, in response to the scan signal SCAN.

The storage capacitor Cst may be connected between the first node N1 and the second node N2 of the driving transistor DRT, and may maintain the voltage of the second node N2 for a certain period of time.

For example, as shown in FIG. 1, each subpixel SP may have a 2T (transistor) 1C (capacitor) structure including two transistors DRT and SCT and one capacitor Cst, but the embodiments of the present disclosure are not limited thereto. As the case may be, each subpixel SP may further include at least one transistor or at least one capacitor.

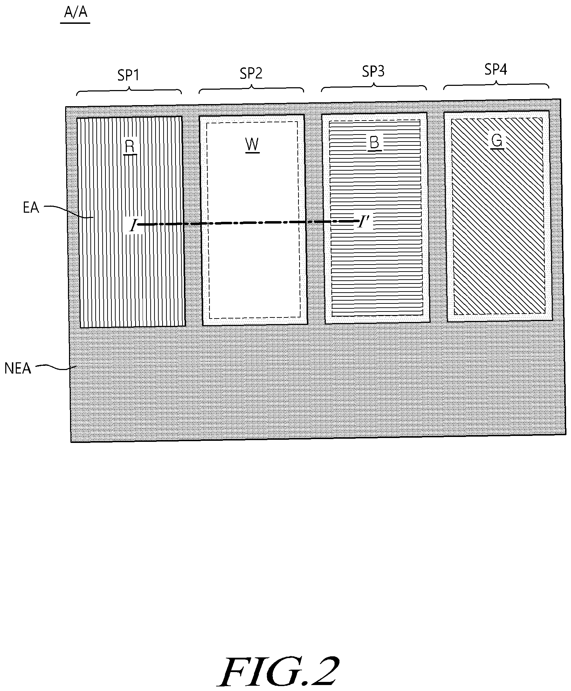

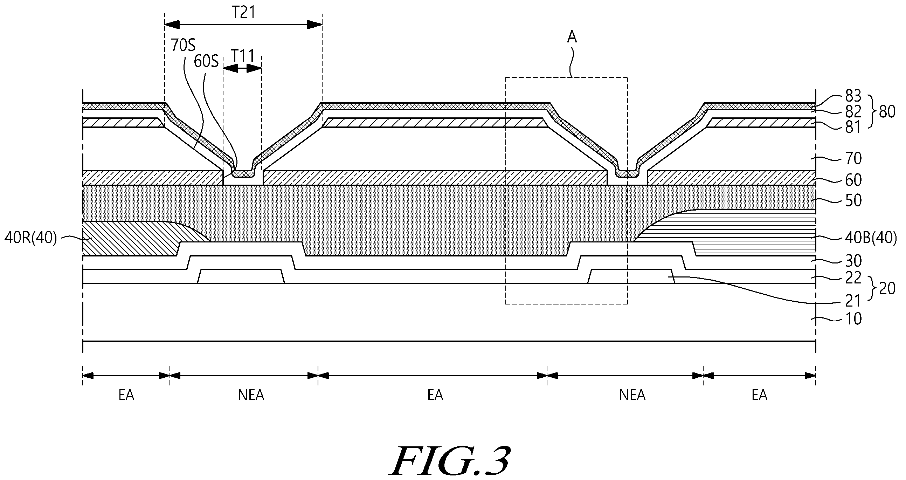

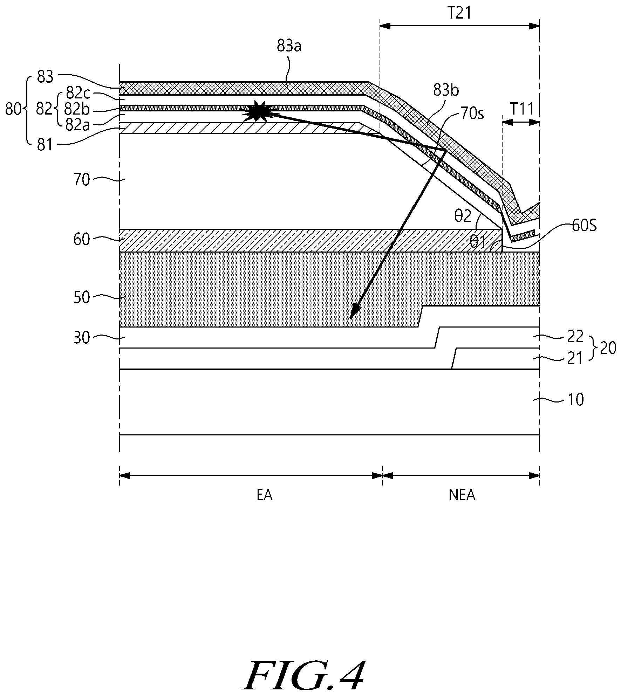

FIG. 2 is a plan view schematically showing pixels disposed in the display panel of a display device according to embodiments of the present disclosure, FIG. 3 is a view showing an example of a cross-section taken along the line I-I' of FIG. 2, and FIG. 4 is an enlarged view of the part A of FIG. 3.

With reference to FIG. 2, a plurality of subpixels SP1 to SP4 are disposed in an active area A/A of the display panel. The subpixels SP1 to SP4 may include a red (R) subpixel SP1, a white (W) subpixel SP2, a blue (B) subpixel SP3 and a green (G) subpixel SP4. As shown in FIG. 2, the subpixels SP1 to SP4 may be disposed in the order of the red subpixel SP1, the white subpixel SP2, the blue subpixel SP3 and the green subpixel SP4, but the disposition order of subpixels is not limited thereto and may be changed in various ways.

In embodiments of the present disclosure, an organic layer that generates white (W) light may be disposed in common in the subpixels SP1 to SP4, a red (R) color filter is disposed in the red subpixel SP1, a blue (B) color filter is disposed in the blue subpixel SP3, and a green (G) color filter is disposed in the green subpixel SP4. A separate color filter is not disposed in the white subpixel SP2.

Each of the subpixels SP1 to SP4 includes a light emitting area EA and a non-light emitting area NEA. The non-light emitting area NEA may be disposed outside the light emitting area EA and may surround the periphery of the light emitting area EA. The non-light emitting area NEA may be disposed between the light emitting areas EA of two neighboring subpixels.

With reference to FIGs. 3 and 4, the display panel of the display device according to the embodiments of the present disclosure may include a substrate 10. A circuit element layer 20 may be disposed on the substrate 10. The circuit element layer 20 may include circuit elements (e.g., driving transistors, sensing transistors and storage capacitors), which constitute subpixels, and wirings 21.

The circuit element layer 20 may include a first conductive layer that is disposed on the substrate 10. The first conductive layer may include a plurality of wirings 21. The wirings 21 may include data lines, driving voltage lines and sensing lines.

The wirings 21 may be disposed in the non-light emitting area NEA between neighboring light emitting areas EA. The first conductive layer may include a light blocking layer and a bottom electrode of each storage capacitor, which are not shown. The light blocking layer may be disposed to overlap the semiconductor pattern of each driving transistor to protect an oxide semiconductor element from external light. The bottom electrode of the storage capacitor may be electrically connected to the gate node of the driving transistor.

The circuit element layer 20 may include a buffer layer 22. The buffer layer 22 may be disposed on the substrate 10 to cover the wirings 21, the light blocking layer and the bottom electrode of the storage capacitor.

The buffer layer 22 may prevent ions or impurities from diffusing from the substrate 10 and block moisture penetration. In addition, the buffer layer 22 may improve surface flatness. The buffer layer 22 may include an inorganic material such as oxide or nitride, an organic material or an organic-inorganic composite, and may be formed in a single-layer or multi-layer structure. For example, the buffer layer 22 may have the structure of at least a triple layer made of silicon oxide, silicon nitride and silicon oxide. In another embodiment, the buffer layer 22 may be omitted.

Although not shown, the circuit element layer 20 may include an active layer, a gate insulating layer and a second conductive layer. The active layer may be disposed on the buffer layer 22. The active layer may be formed of a silicon-based semiconductor material or an oxide-based semiconductor material. As the silicon-based semiconductor material, amorphous silicon or polycrystalline silicon may be used. As the oxide-based semiconductor material, quaternary metal oxide such as indium tin gallium zinc oxide (InSnGaZnO), ternary metal oxide such as indium gallium zinc oxide (InGaZnO), indium tin zinc oxide (InSnZnO), indium aluminum zinc oxide (InAlZnO), tin gallium zinc oxide (SnGaZnO), aluminum gallium zinc oxide (AlGaZnO) and tin aluminum zinc oxide (SnAlZnO), binary metal oxide such as indium zinc oxide (InZnO), tin zinc oxide (SnZnO), aluminum zinc oxide (AlZnO), zinc magnesium oxide (ZnMgO), tin magnesium oxide (SnMgO), indium magnesium oxide (InMgO) and indium gallium oxide (InGaO), or mono-metal oxide such as indium oxide (InO), tin oxide (SnO) and zinc oxide (ZnO) may be used. The active layer may include a source area, a drain area and a channel area between the source area and the drain area.

The gate insulating layer may be disposed on the active layer. The second conductive layer may be disposed on the gate insulating layer. The second conductive layer may include a gate electrode, a source electrode and a drain electrode. The second conductive layer may further include a top electrode of the storage capacitor.

A first passivation layer 30 may be disposed on the circuit element layer 20. The first passivation layer 30 may cover the second conductive layer (not shown) and the buffer layer 22 that is not covered by the second conductive layer. The first passivation layer 30 may include a photosensitive organic material. The first passivation layer 30 may be formed as an inorganic insulating layer such as silicon nitride (SiNx) and silicon oxide (SiOx) or an organic insulating layer such as polyacrylate and polyimide, and the embodiments of the present disclosure are not limited thereto.

A color filter 40 may be disposed on the first passivation layer 30. The color filter 40 is a wavelength-selective optical filter that selectively transmits only a part of the wavelength band of incident light by transmitting light of a specific wavelength band and blocking light of another specific wavelength band, and may be made of photosensitive resin including a colorant such as a pigment or dye.

When a subpixel displays red (R) color, a red color filter 40R may be disposed in the light emitting area EA of the corresponding subpixel. When a subpixel displays blue (B) color, a blue color filter 40B may be disposed in the light emitting area EA of the corresponding subpixel. When a subpixel displays green (G) color, a green color filter (not shown) may be disposed in the light emitting area EA of the corresponding subpixel. Light having passed through the color filter 40 may have any one color of red (R), green (G) and blue (B). When a subpixel displays white (W) color, a color filter may be omitted in the light emitting area EA of the corresponding subpixel.

A first overcoat layer 50 may be disposed on the first passivation layer 30 and the color filter 40. The first overcoat layer 50 may be disposed on the first passivation layer 30 to cover the color filter 40. The first overcoat layer 50 may include an organic material such as polyimide, benzocyclobutene series resin or acrylate.

A second passivation layer 60 may be disposed on the first overcoat layer 50. The second passivation layer 60 may include a photosensitive organic material. The second passivation layer 60 may be formed as an inorganic insulating layer such as silicon nitride (SiNx) and silicon oxide (SiOx) or an organic insulating layer such as polyacrylate and polyimide, and the embodiments of the present disclosure are not limited thereto.

A first trench T11 may be formed in the second passivation layer 60 between neighboring light emitting areas EA. The first trench T11 may pass through the second passivation layer 60 to expose a portion of the first overcoat layer 50. The first trench T11 may expose the side surface (a first sloped surface) 60S of the second passivation layer 60.

A second overcoat layer 70 is disposed on the second passivation layer 60. The second overcoat layer 70 may include an organic material such as polyimide, benzocyclobutene series resin or acrylate. The first and second overcoat layers 50 and 70 may prevent outgassing generated from the color filter 40 from being transferred to a light emitting element 80 that is disposed on the second overcoat layer 70.

A second trench T21 that exposes the first trench T11 may be formed in the second overcoat layer 70. The second trench T21 may have a tapered shape whose dimension decreases toward the substrate 10. The side surface (a second sloped surface) 70S of the second overcoat layer 70 may be exposed by the second trench T21. The second sloped surface 70S of the second overcoat layer 70 may be provided in the shape of a side ring along the edge of the light emitting area EA.

The first sloped surface 60S of the second passivation layer 60 exposed through the first trench T11 may have a first slope angle θ1. The second sloped surface 70S of the second overcoat layer 70 exposed through the second trench T21 may have a second slope angle θ2 that is different from the first slope angle θ1. The first slope angle θ1 may be larger than the second slope angle θ2. The first sloped surface 60S may have a steeper slope than the second sloped surface 70S.

The first trench T11 may be formed by etching the second passivation layer 60 exposed by the second trench T21. In an embodiment, the first trench T11 may be self-aligned with the second trench T21. Although not shown, in another embodiment, as the second passivation layer 60 is over-etched during an etching process for forming the first trench T 11, the top of the first trench T11 may have a dimension larger than the bottom of the second trench T21. In this case, an undercut structure in which the edge of the first trench T 11 is covered with the second overcoat layer 70 may be formed.

A first electrode 81 that exposes the first and second trenches T11 and T21 is disposed on the second overcoat layer 70. The first electrode 81 may be the pixel electrode or the anode electrode of the light emitting element 80. The first electrode 81 may be a transparent electrode. The first electrode 81 may be a reflective electrode. The first electrode 81 may include a reflective layer. The reflective layer may be made of aluminum (Al), copper (Cu), silver (Ag), nickel (Ni) or an alloy thereof. In an embodiment, the reflective layer may be made of APC (silver/palladium/copper alloy).

The second trench T21 may be formed by etching the second overcoat layer 70 that is not covered by the first electrode 81. In an embodiment, the second trench T21 may be self-aligned with the first electrode 81.

An organic layer 82 may be disposed on the first electrode 81, the second sloped surface 70S of the second overcoat layer 70 and the first sloped surface 60S of the second passivation layer 60. The organic layer 82 may be formed in common for a plurality of subpixels without a shadow mask.

The organic layer 82 may have a structure in which a plurality of layers are stacked. For example, the organic layer 82 may have a tandem structure. The organic layer 82 may include a first light emitting unit 82a, a charge generation layer 82b that is disposed on the first light emitting unit 82a, and a second light emitting unit 82c that is disposed on the charge generation layer 82b.

Although not shown, the first light emitting unit 82a may include a hole injection layer, a first hole transport layer, a first light emitting material layer and a first electron transport layer. The first hole transport layer is located between the hole injection layer and the first light emitting material layer, the first light emitting material layer is located between the first hole transport layer and the first electron transport layer, and the first electron transport layer is located between the first light emitting material layer and the charge generation layers 82b. The hole injection layer may be omitted depending on the structure or characteristics of a light emitting element.

The second light emitting unit 82c may include a second hole transport layer, a second light emitting material layer, a second electron transport layer and an electron injection layer. The second hole transport layer is located between the charge generation layer 82b and the second light emitting material layer, the second light emitting material layer is located between the second hole transport layer and the second electron transport layer, and the electron injection layer is located between the second electron transport layer and a second electrode 83.

The hole injection layer serves to facilitate the injection of holes, and the electron injection layer serves to facilitate the injection of electrons. The first hole transport layer and the second hole transport layer serve to facilitate the transport of holes in the first light emitting unit 82a and the second light emitting unit 82c, respectively. The first electron transport layer and the second electron transport layer serve to facilitate the transport of electrons in the first light emitting unit 82a and the second light emitting unit 82c, respectively.

The first and second light emitting material layers may be made by doping hosts with dopants, and may emit different colors. The first light emitting material layer may emit light of a first wavelength and light of a second wavelength, and the second light emitting material layer may emit light of a third wavelength. The light of the first wavelength and the light of the second wavelength emitted from the first light emitting material layer and the light of the third wavelength emitted from the second light emitting material layer may be mixed with each other to implement white light. For example, the first light emitting material layer may emit blue (B), red (R), green (G) or yellow (Y). When the first light emitting material layer is a blue light emitting material layer, the first light emitting material layer includes one of a blue light emitting material layer, a dark blue light emitting material layer and a sky blue light emitting material layer. Alternatively, the first light emitting material layer may be composed of a blue (B) light emitting material layer and a red (R) light emitting material layer, a blue (B) light emitting material layer and a yellow-green (YG) light emitting material layer, or a blue (B) light emitting material layer and a green (G) light emitting material layer. The second light emitting material layer may be any one of red (R), green (G), blue (B) and yellow-green (YG) light emitting material layers.

The charge generation layer 82b is disposed between the first light emitting unit 82a and the second light emitting unit 82c, and may include an N-type charge generation layer that is located adjacent to the first light emitting unit 82a and a P-type charge generation layer that is located adjacent to the second light emitting unit 82c. The N-type charge generation layer injects electrons into the first light emitting unit 82a, and the P-type charge generation layer injects holes into the second light emitting unit 82c.

At least one of the plurality of layers included in the organic layer 82 may be cut in an area including the boundary between the first sloped surface 60S and the second sloped surface 70S. For example, the charge generation layer 82b of the organic layer 82 may be cut. The area including the boundary between the first sloped surface 60S and the second sloped surface 70S may be disposed between neighboring light emitting areas EA, and the charge generation layer 82b may be cut between the light emitting areas EA of neighboring subpixels.

The second electrode 83 of the light emitting element 80 may be disposed on the organic layer 82. The second electrode 83 may be a reflective electrode. For example, the second electrode 83 may be made of any one selected from the group consisting of silver (Ag), aluminum (Al), magnesium (Mg), chromium (Cr), titanium (Ti), nickel (Ni), tungsten (W), gold (Au), tantalum (Ta), copper (Cu), cobalt (Co), iron (Fe), molybdenum (Mo) and platinum (Pt) or an alloy of the metals.

The second electrode 83 includes a first portion 83a that overlaps the first electrode 81 and a second portion 83b that overlaps the second sloped surface 70S of the second overcoat layer 70.

The first portion 83a of the second electrode 83 may constitute the light emitting element 80. The light emitting element 80 may include the first electrode 81, the first portion 83a of the second electrode 83 and the organic layer 82 disposed therebetween. By the difference between voltages applied to the first electrode 81 and the second electrode 83, light may be generated in the organic layer 82 between the first electrode 81 and the first portion 83a of the second electrode 83.

The second portion 83b of the second electrode 83 may have a slope corresponding to the second slope angle θ2 of the second sloped surface 70S of the second overcoat layer 70. The second portion 83b of the second electrode 83 may have the shape of a side ring that surrounds the periphery of the light emitting area EA.

The second portion 83b of the second electrode 83 may play the role of increasing light extraction efficiency by reflecting light generated in the organic layer 82 between the first electrode 81 and the first portion 83a of the second electrode 83. Light extraction efficiency may vary depending on the slope angle of the second portion 83b of the second electrode 83. The size of the second slope angle θ2 of the second sloped surface 70S of the second overcoat layer 70 corresponding to the slope angle of the second portion 83b of the second electrode 83 may be set to increase light extraction efficiency.

Although not shown, a third passivation layer that covers the second electrode 83 may be disposed on the second electrode 83, an encapsulation layer may be disposed on the side surface and the top surface of the third passivation layer, and an encapsulation substrate may be attached onto the third passivation layer through the encapsulation layer.

Voltages may be independently provided to the first electrodes 81 of light emitting elements 80. Accordingly, the light emitting elements 80 may be independently controlled, and subpixels may generate independently controlled amounts of light. If the charge generation layer 82b is continuously formed without being cut between the light emitting areas EA of neighboring subpixels, an unintended subpixel may emit light due to side leakage current flowing through the charge generation layer 82b with high hole and electron mobility. For example, even in a case where only the light emitting element of a blue subpixel is driven and the light emitting element of a green subpixel and the light emitting element of a red subpixel are not driven, a phenomenon may occur in which even the green subpixel and the red subpixel emit light. In order to emit pure blue light, a voltage is applied between the first and second electrodes of the blue subpixel, but the phenomenon occurs in which even the red subpixel and the green subpixel are also turned on due to side leakage current. If an unintended subpixel emits light in this way, color gamut may deteriorate, and in particular, spots or color abnormalities may be visible when displaying an image of a low grayscale.

According to the embodiments of the present disclosure, by disposing the second passivation layer 60 under the second overcoat layer 70, forming the first trench T11 by etching the second passivation layer 60 under the second trench T21 to increase the depth of a trench under the organic layer 82 and configuring the first sloped surface 60S exposed by the first trench T11 to have a steeper slope than the second sloped surface 70S exposed by the second trench T21, at least one layer of the layers included in the organic layer 82, for example, the charge generation layer 82b, may be cut in the area including the boundary between the first sloped surface 60S and the second sloped surface 70S.

The thickness of the second passivation layer 60 corresponding to the depth of the first trench T11 and the first slope angle θ1 of the first sloped surface 60S exposed by the first trench T11 are determined so that the charge generation layer 82b is cut in the area including the boundary between the first sloped surface 60S and the second sloped surface 70S when depositing the organic layer 82. The thickness and the first slope angle θ1 of the second passivation layer 60 may be set to values that enable cutting of the charge generation layer 82b.

As another example not shown, in the area including the boundary between the first sloped surface 60S and the second sloped surface 70S, the edge of the first trench T11 may be formed into an undercut structure to be covered with the second overcoat layer 70. In this case, due to a shadow effect caused by the undercut structure, because the charge generation layer 82b is not formed between the first sloped surface 60S and the second sloped surface 70S, a cutting effect may be increased.

According to the embodiments of the present disclosure, because the charge generation layer 82b is cut in the area including the boundary between the first sloped surface 60S and the second sloped surface 70S, side leakage current between neighboring subpixels may be suppressed. Due to this fact, it is possible to suppress an unintended subpixel from emitting light, charge injection efficiency may be improved, and luminous efficiency may be enhanced. In addition, color gamut may be improved by preventing color mixing, and the visual recognition of spots or color abnormalities when displaying an image of a low grayscale may be reduced.

In addition, because there is no need to leave a gap between the first electrode 81 and the second trench T21 of the light emitting element to suppress side leakage current, aperture ratio may be improved by increasing the area of the light emitting area EA. Accordingly, light extraction efficiency is improved, and the amount of light emitted from the display device increases to increase luminance. Furthermore, because a sufficient amount of light may be emitted with a low voltage, it is also possible to reduce power consumption. As light efficiency is improved, a viewing angle and luminance may be increased, whereby it is possible to provide a wide viewing angle.

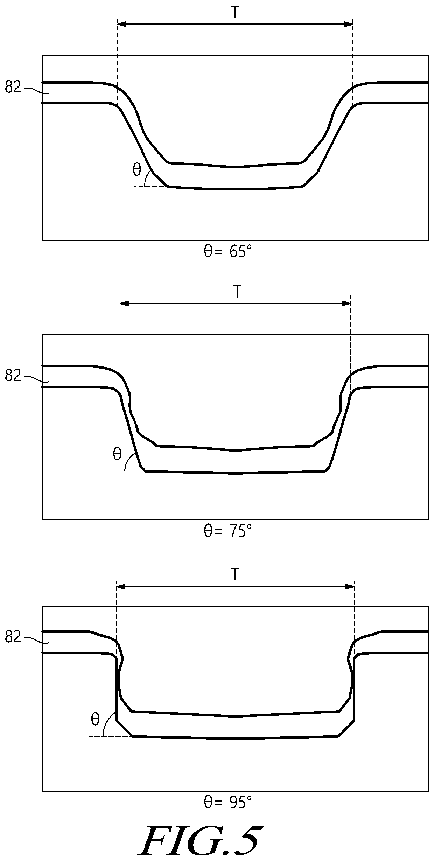

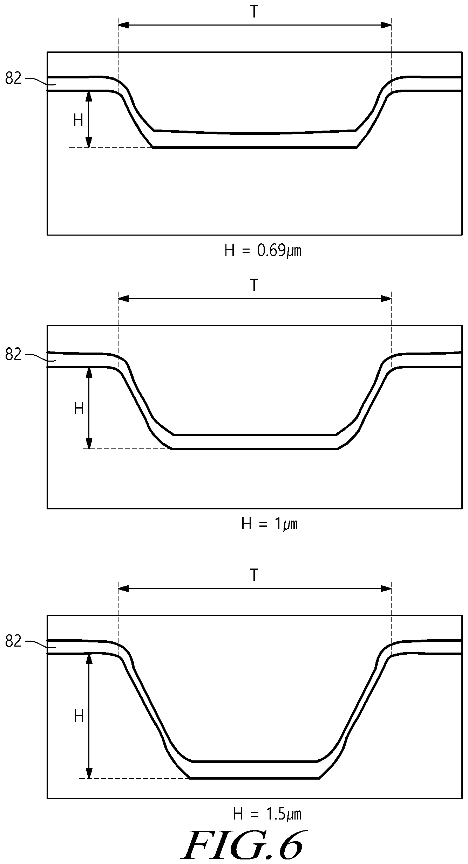

FIG. 5 is of views showing changes in the profile of an organic layer depending on a change in the slope angle of the side surface of a trench under the organic layer, and FIG. 6 is of views showing changes in the profile of an organic layer depending on a change in the depth of a trench under the organic layer.

With reference to FIG. 5, the thickness of the organic layer 82 deposited on the side surface of a trench T is thickest when a slope angle θ of the side surface of the trench T is 65°, is next thickest when a slope angle θ of the side surface of the trench T is 75°, and is thinnest when a slope angle θ of the side surface of the trench T is 90°. In other words, as a slope angle θ of the side surface of the trench T increases to 65°, 75°, and 90°, the thickness of the organic layer 82 deposited on the side surface of the trench T decreases.

With reference to FIG. 6, the thickness of the organic layer 82 deposited on the side surface of a trench T is thickest when a depth H of the trench T is 0.69µm, is next thickest when a depth H of the trench T is 1µm, and is thinnest when a depth H of the trench T is 1.5 µm. As a depth H of the trench T increases to 0.69µm, 1µm and 1.5µm, the thickness of the organic layer 82 deposited on the side surface of the trench T decreases.

The thickness of the organic layer 82 deposited on the side surface of the trench T decreases as a slope angle θ of the side surface of the trench T is large and a depth H of the trench T is deep. The embodiments of the present disclosure may provide measures capable of suppressing side leakage current by cutting the charge generation layer 82b of the organic layer 82 between neighboring subpixels through increasing the depth of a trench disposed under the organic layer 82 between neighboring subpixels and increasing the slope angle of the side surface of the trench.

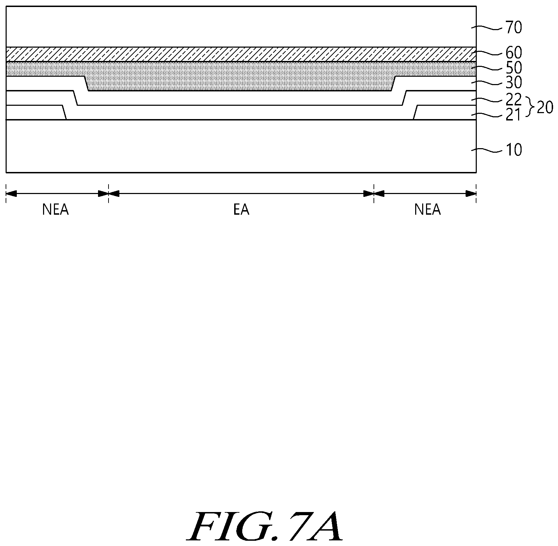

FIGs. 7A to 7E are cross-sectional views showing a method of manufacturing the display panel of a display device according to embodiments of the present disclosure, and show a method of manufacturing the display panel of the display device of FIGs. 3 and 4.

With reference to FIG. 7A, a circuit element layer 20 is formed on a substrate 10, and a first passivation layer 30 is formed on the circuit element layer 20. A color filter (not shown) is formed on the first passivation layer 30, and a first overcoat layer 50 is formed to cover the color filter and the first passivation layer 30. A second passivation layer 60 is formed on the first overcoat layer 50, and a second overcoat layer 70 is formed on the second passivation layer 60.

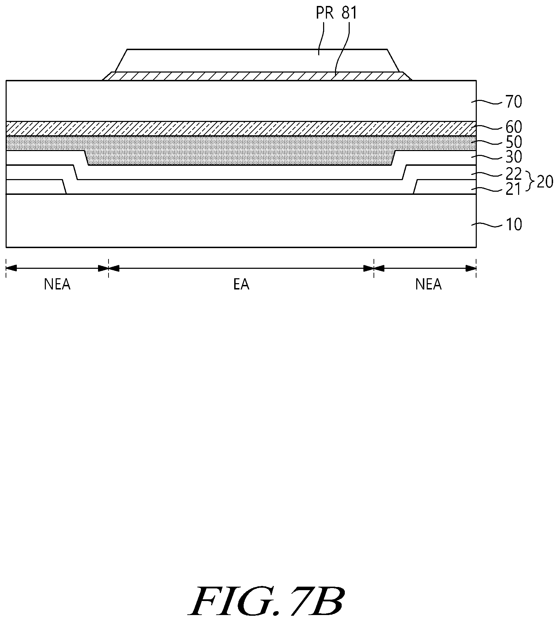

With reference to FIG. 7B, a conductive layer is formed on the second overcoat layer 70, a mask pattern PR is formed on the conductive layer, and then, a first electrode 81 is formed by etching the conductive layer using the mask pattern PR as an etch mask.

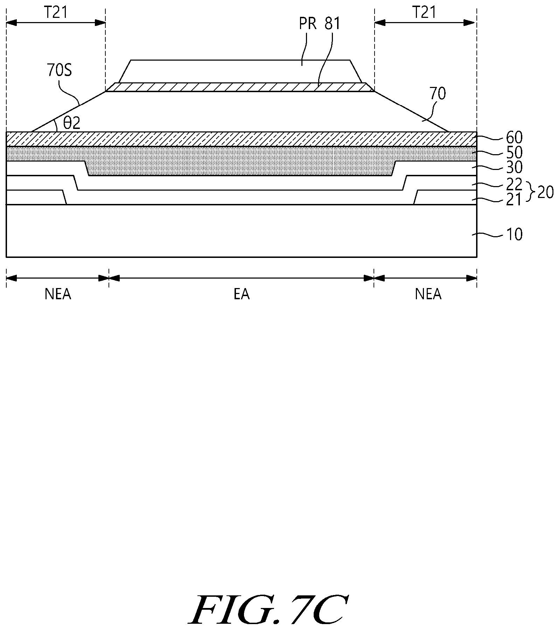

With reference to FIG. 7C, a second trench T21 is formed by etching the second overcoat layer 70 using the mask pattern PR as an etch mask. A dry etching process may be used as an etching process. A second sloped surface 70S of the second overcoat layer 70 may be exposed through the second trench T21. The second sloped surface 70S has a second slope angle θ2.

In the embodiments of the present disclosure, because a separate mask pattern is not used to form the second trench T21 and the second trench T21 is formed by etching the second overcoat layer 70 using the mask pattern PR used in etching the conductive layer to form the first electrode 81, the number of mask patterns is reduced compared to a case where a separate mask pattern is used to form the second trench T21.

Because the second trench T21 is formed by etching the second overcoat layer 70 using the mask pattern PR used in forming the first electrode 81, the second trench T21 may be self-aligned with the first electrode 81. In a case where the second overcoat layer 70 is over-etched during the etching process and thus the first electrode 81 protrudes beyond the second sloped surface 70S, an etching process for removing the protruding portion of the first electrode 81 may also be carried out.

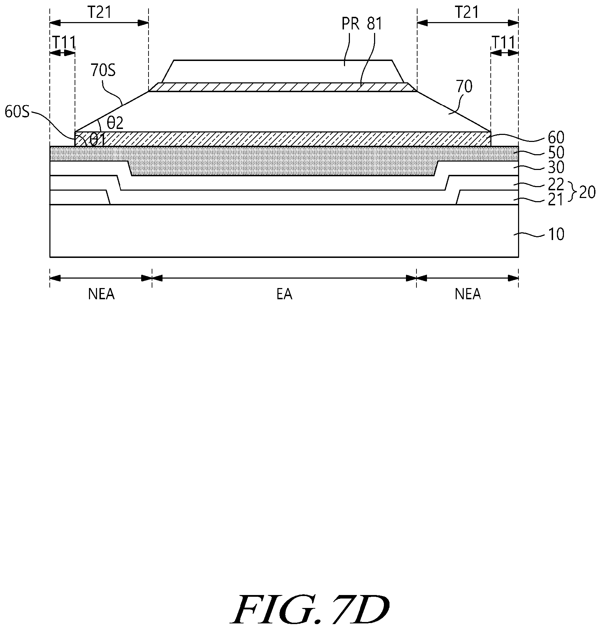

With reference to FIG. 7D, a first trench T11 is formed by etching the second passivation layer 60 exposed through the second trench T21. Because the first trench T11 is formed by etching the exposed portion of the second passivation layer 60 by the second trench T21, the first trench T11 may be self-aligned with the second trench T21. A wet etching process may be used as an etching process. A first sloped surface 60S of the second passivation layer 60 may be exposed through the first trench T11. The first sloped surface 60S has a first slope angle θ1. The etching process is controlled so that the first slope angle θ1 has a slope angle different from the second slope angle θ2. The etching process may be controlled so that the first slope angle θ1 has a larger value than the second slope angle θ2.

Although not shown, by over-etching the second passivation layer 60 in the process of etching the second passivation layer 60, it is possible to cause the top of the first trench T11 to have a larger dimension than the bottom of the second trench T21. In this case, an undercut structure in which the edge of the first trench T11 is covered with the second overcoat layer 70 may be formed. The mask pattern PR may be formed of photoresist, and the mask pattern PR that remains after forming the first trench T11 may be removed through a strip process.

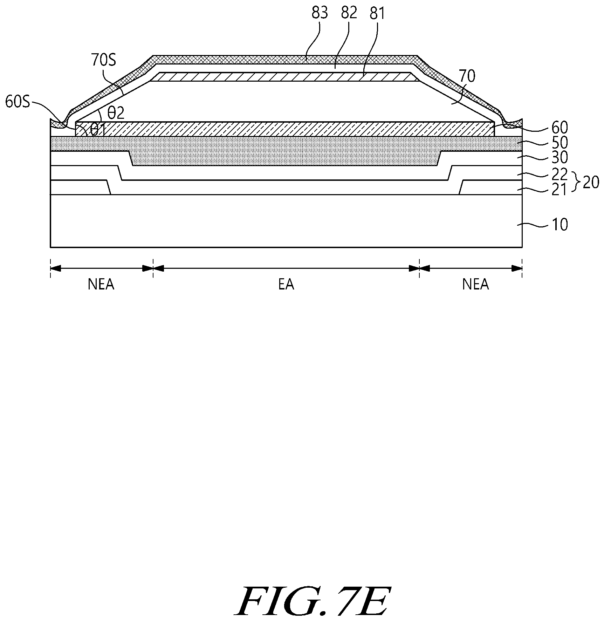

With reference to FIG. 7E, an organic layer 82 is formed on an entire surface including the first electrode 81, the first sloped surface 60S of the second passivation layer 60 and the second sloped surface 70S of the second overcoat layer 70, and a second electrode 83 of a light emitting element is formed on the organic layer 82.

The organic layer 82 may have a structure in which a plurality of layers are stacked. For example, the organic layer 82 may have a tandem structure. The organic layer 82 may include a first light emitting unit, a charge generation layer that is disposed on the first light emitting unit, and a second light emitting unit that is disposed on the charge generation layer.

The organic layer 82 is deposited in common for subpixels without a shadow mask. Although the organic layer 82 is deposited in common for the subpixels, by forming the first trench T11 in the second passivation layer 60 under the second trench T21 to increase the depth of a trench under the organic layer 82, configuring the first sloped surface 60S exposed by the first trench T11 to have a steeper slope than the second sloped surface 70S exposed by the second trench T21 and additionally configuring the undercut structure, at least one of the plurality of layers included in the organic layer 82 may be cut in an area including the boundary between the first sloped surface 60S and the second sloped surface 70S. For example, the charge generation layer of the organic layer 82 may be cut. Thereafter, although not shown, a third passivation layer that covers the second electrode 83 is formed on the second electrode 83, an encapsulation layer that seals the side surface and the top surface of the third passivation layer is formed, and an encapsulation substrate is attached onto the encapsulation layer.

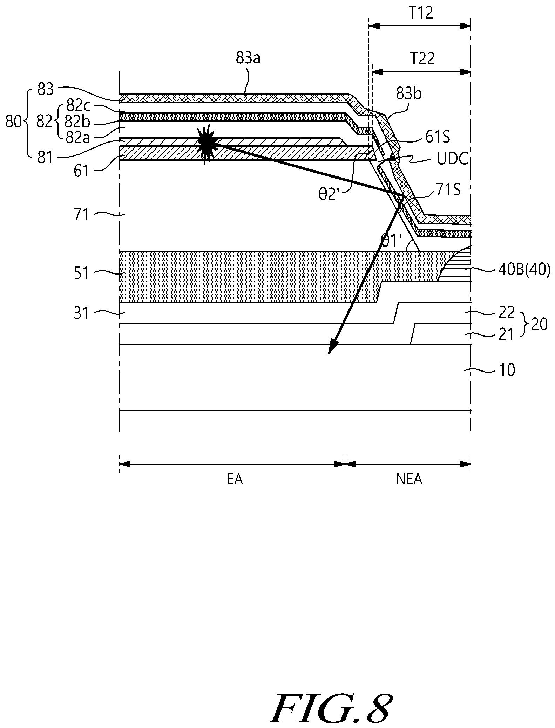

FIG. 8 is a view showing an example of a cross-section of the display panel of a display device according to embodiments of the present disclosure.

With reference to FIG. 8, a circuit element layer 20 may be disposed on a substrate 10, and a first passivation layer 31 may be disposed on the circuit element layer 20. The first passivation layer 31 may cover the circuit element layer 20. A color filter 40 is disposed on the first passivation layer 31, and a first overcoat layer 51 is disposed on the color filter 40 and the first passivation layer 31. The first overcoat layer 51 may be formed without a mask to cover the color filter 40 and the first passivation layer 31.

A second overcoat layer 71 is disposed on the first overcoat layer 51. As the second overcoat layer 71 is opened between light emitting areas EA of neighboring subpixels, a first trench T12 is formed. The first trench T12 may have a tapered shape whose dimension decreases toward the substrate 10. A side surface (a first sloped surface) 71S of the second overcoat layer 71 may be exposed through the first trench T12. The first sloped surface 71S of the second overcoat layer 71 exposed through the first trench T12 may have a first slope angle θ1'.

A second passivation layer 61 is disposed on the second overcoat layer 71. A second trench T22 that exposes the first trench T12 may be formed in the second passivation layer 61. A side surface (a second sloped surface) 61S of the second passivation layer 61 may be exposed through the second trench T22.

The second sloped surface 61S of the second passivation layer 61 exposed through the second trench T22 may have a second slope angle θ2' different from the first slope angle θ1'. The second slope angle θ2' may be larger than the first slope angle θ1'. The second sloped surface 61S may have a steeper slope than the first sloped surface 71S. The first trench T12 and the second trench T22 may be formed through an etching process using a single mask.

As the second overcoat layer 71 is over-etched due to the difference in etch rate between the second overcoat layer 71 and the second passivation layer 61, the top of the first trench T12 may have a dimension larger than the bottom of the second trench T22. In this case, an undercut structure UDC in which the edge of the first trench T12 is covered with the second passivation layer 61 may be formed.

A first electrode 81 that exposes the first and second trenches T12 and T22 is disposed on the second passivation layer 61. The first electrode 81 may be the pixel electrode or the anode electrode of a light emitting element 80.

An organic layer 82 may be disposed on the first electrode 81, the first sloped surface 71S of the second overcoat layer 71 and the second sloped surface 61S of the second passivation layer 61. The organic layer 82 may be formed in common for a plurality of subpixels without a shadow mask.

The organic layer 82 may have a structure in which a plurality of layers are stacked. For example, the organic layer 82 may include a first light emitting unit 82a that is disposed on the first electrode 81, a charge generation layer 82b that is disposed on the first light emitting unit 82a, and a second light emitting unit 82c that is disposed on the charge generation layer 82b.

At least one of the plurality of layers of the organic layer 82 may be cut in an area including the boundary between the first sloped surface 71S and the second sloped surface 61S. For example, the charge generation layer 82b may be cut in an area including the boundary between the first sloped surface 71S and the second sloped surface 61S. The area including the boundary between the first sloped surface 71S and the second sloped surface 61S may be disposed between neighboring light emitting areas EA, and the charge generation layer 82b may be cut between the light emitting areas EA of neighboring subpixels.

According to the embodiments of the present disclosure, by disposing the second passivation layer 61 on the second overcoat layer 71, forming the second trench T22 by etching the second passivation layer 61 on the first trench T12 to increase the depth of a trench under the organic layer 82, configuring the second sloped surface 61S exposed by the second trench T22 to have a steeper slope than the first sloped surface 71S exposed by the first trench T12 and configuring the undercut structure between the firs sloped surface 71S and the second sloped surface 61S, at least one of the plurality of layers constituting the organic layer 82, for example, the charge generation layer 82b, may be cut in the area including the boundary between the first sloped surface 71S and the second sloped surface 61S.

The thickness of the second passivation layer 61 corresponding to the depth of the second trench T22 and the second slope angle θ2' of the second sloped surface 61S exposed by the second trench T22 are determined so that the charge generation layer 82b is cut in the area including the boundary between the first sloped surface 71S and the second sloped surface 61S when depositing the charge generation layer 82b. The thickness and the second slope angle θ2' of the second passivation layer 61 may be set to values that enable cutting of the charge generation layer 82b.

A second electrode 83 of the light emitting element 80 may be disposed on the organic layer 82. The second electrode 83 includes a first portion 83a that overlaps the first electrode 81 and a second portion 83b that overlaps the first sloped surface 71S of the second overcoat layer 71 and the second sloped surface 61S of the second passivation layer 61.

The first portion 83a of the second electrode 83 may constitute the light emitting element 80. The light emitting element 80 may be constituted by the first electrode 81, the first portion 83a of the second electrode 83 and the organic layer 82 disposed therebetween. By the difference between voltages applied to the first electrode 81 and the second electrode 83, light may be generated in the organic layer 82 between the first electrode 81 and the first portion 83a of the second electrode 83.

A portion of the second portion 83b of the second electrode 83 has a slope corresponding to the first slope angle θ1' of the first sloped surface 71S of the second overcoat layer 71, and the other portion has a slope corresponding to the second slope angle θ2' of the second sloped surface 61S of the second passivation layer 61. The second portion 83b of the second electrode 83 may play the role of reflecting light emitted in the organic layer 82 between the first electrode 81 and the first portion 83a of the second electrode 83 and extracting the light to the outside of the display panel. The second portion 83b of the second electrode 83 may play the role of increasing light extraction efficiency by reflecting light generated in the organic layer 82 of the light emitting area EA.

Although not shown, a third passivation layer may be disposed on the second electrode 83, an encapsulation layer may be disposed on the third passivation layer, and an encapsulation substrate may be attached onto the third passivation layer through the encapsulation layer.

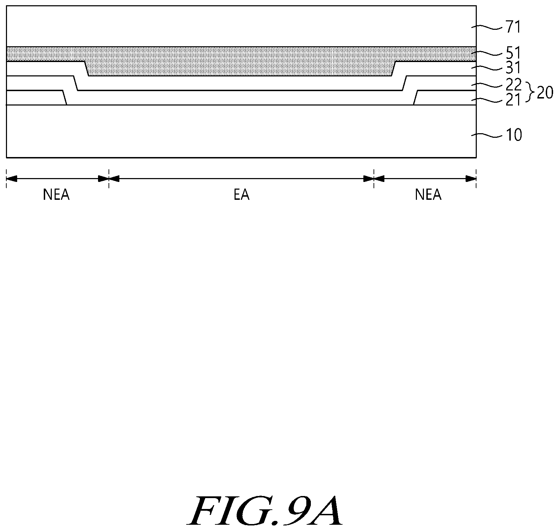

FIGs. 9A to 9E are cross-sectional views showing a method of manufacturing the display panel of a display device according to embodiments of the present disclosure, and show a method of manufacturing the display panel of the display device of FIG. 8.

With reference to FIG. 9A, a circuit element layer 20 is formed on a substrate 10, and a first passivation layer 31 is formed to cover the circuit element layer 20. A color filter (not shown) is formed on the first passivation layer 31, a first overcoat layer 51 is formed to cover the color filter and the first passivation layer 31, and a second overcoat layer 71 is formed on the first overcoat layer 51.

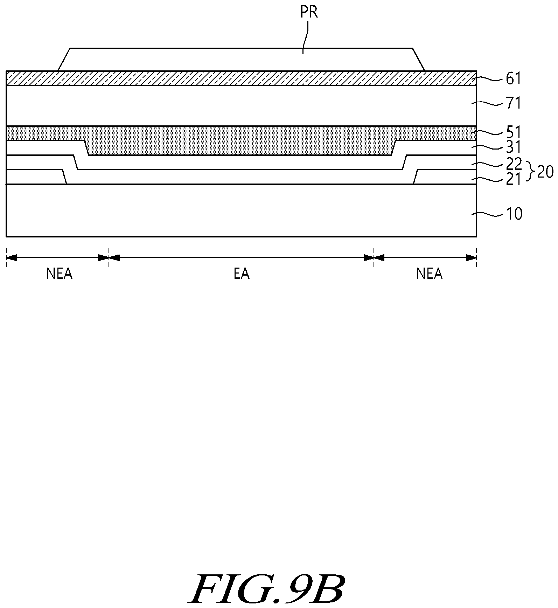

With reference to FIG. 9B, a second passivation layer 61 is formed on the second overcoat layer 71, and a mask pattern PR is formed on the second passivation layer 61.

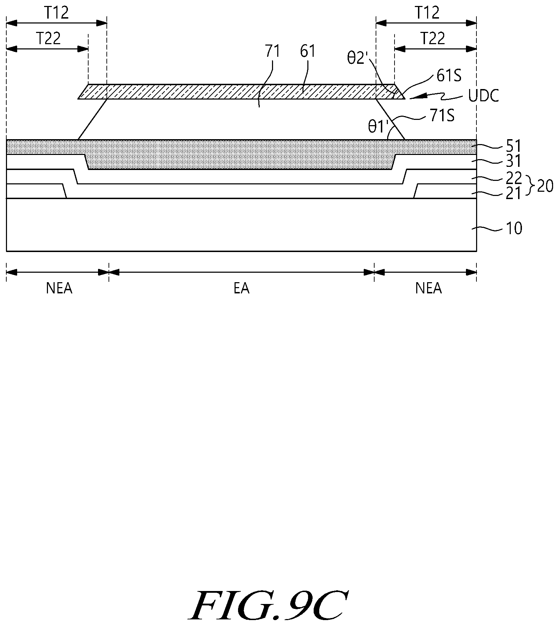

With reference to FIG. 9C, by etching the second passivation layer 61 and the second overcoat layer 71 using the mask pattern PR as an etch mask, a first trench T12 is formed in the second overcoat layer 71, and a second trench T22 is formed in the second passivation layer 61. A dry etching process may be used as an etching method.

The first trench T12 may have a tapered shape whose dimension decreases toward the top surface of the substrate 10. A first sloped surface 71S of the second overcoat layer 71 may be exposed through the first trench T12. A second sloped surface 61S of the second passivation layer 61 may be exposed through the second trench T22.

Due to the difference in etch rate between the second overcoat layer 71 and the second passivation layer 61, a first slope angle θ1' and a second slope angle θ2' may have different sizes. The second slope angle θ2' may be larger than the first slope angle θ1'. Namely, the second sloped surface 61S may have a steeper slope than the first sloped surface 71S.

In addition, as the second overcoat layer 71 is over-etched due to the difference in etch rate between the second overcoat layer 71 and the second passivation layer 61, the top of the first trench T12 may have a dimension larger than the bottom of the second trench T22. Accordingly, an undercut structure UDC in which the edge of the first trench T12 is covered with the second passivation layer 61 may be formed. The mask pattern PR may be formed of photoresist, and the mask pattern PR that remains after forming the first and second trenches T12 and T22 may be removed through a strip process.

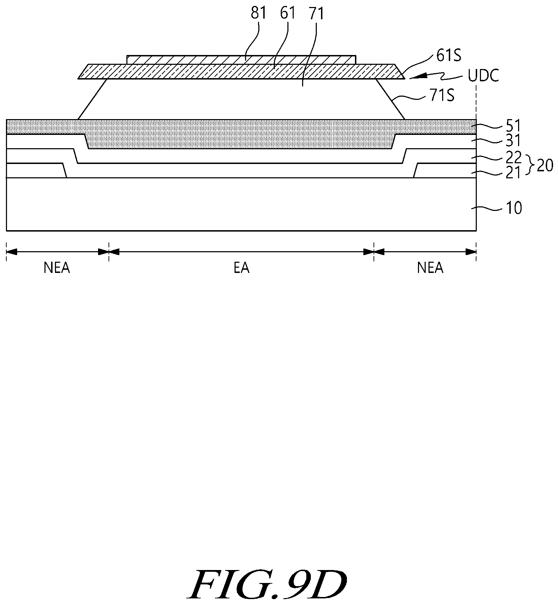

With reference to FIG. 9D, a first electrode 81 is formed on the second passivation layer 61. The first electrode 81 is formed by forming a conductive layer on the second passivation layer 61, forming a mask pattern (not shown) on the conductive layer and etching the conductive layer using the mask pattern as an etch mask.

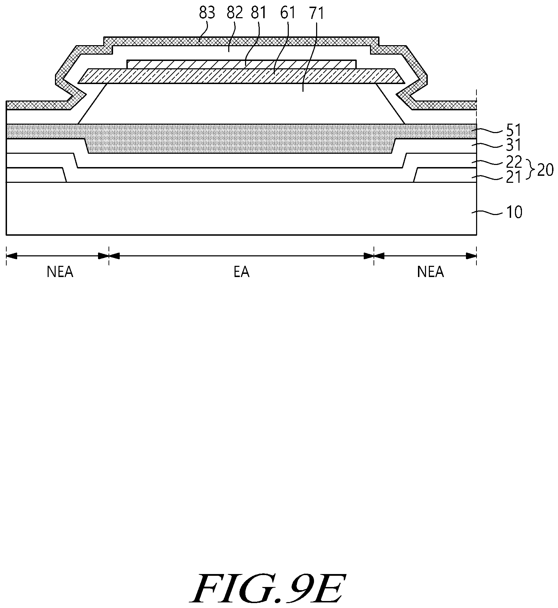

With reference to FIG. 9E, an organic layer 82 is formed on an entire surface including the first electrode 81, the first sloped surface 71S of the second overcoat layer 71 and the second sloped surface 61S of the second passivation layer 61, and a second electrode 83 of a light emitting element is formed on the organic layer 82.

The organic layer 82 is deposited in common for subpixels without a shadow mask. Although the organic layer 82 is deposited in common for the subpixels, by forming the second trench T22 in the second passivation layer 61 on the first trench T12 to increase the depth of a trench under the organic layer 82, configuring the second sloped surface 61S exposed by the second trench T22 to have a steeper slope than the first sloped surface 71S exposed by the first trench T12 and configuring the undercut structure, at least one of a plurality of layers included in the organic layer 82 may be cut in an area including the boundary between the first sloped surface 71S and the second sloped surface 61S. For example, a charge generation layer of the organic layer 82 may be cut. Thereafter, although not shown, a third passivation layer that covers the second electrode 83 is formed on the second electrode 83, an encapsulation layer that seals the side surface and the top surface of the third passivation layer is formed, and an encapsulation substrate is attached onto the encapsulation layer.

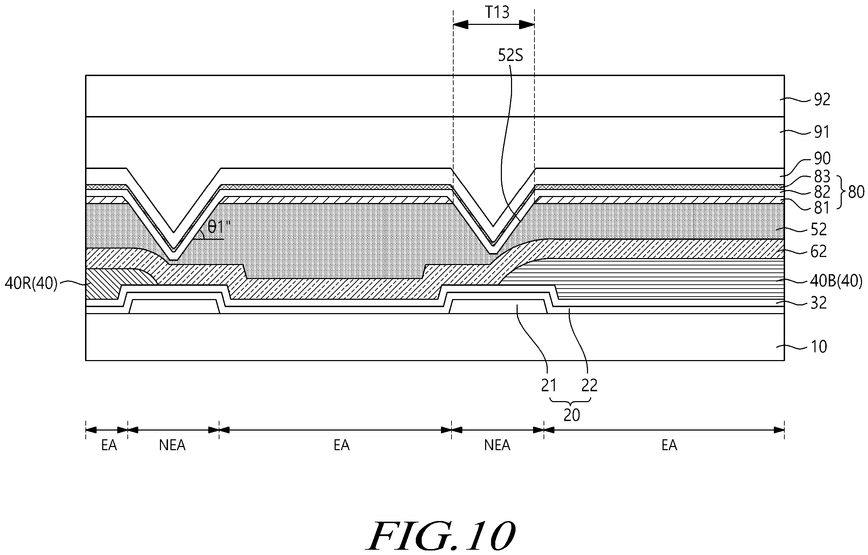

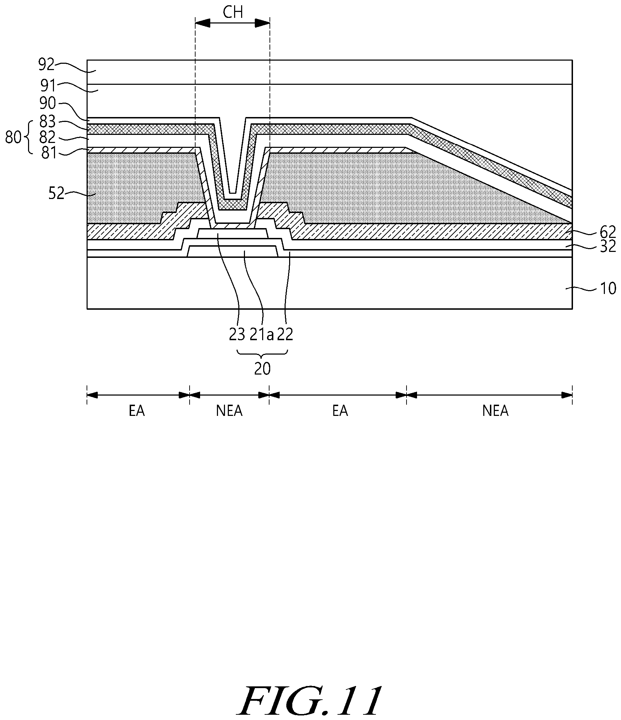

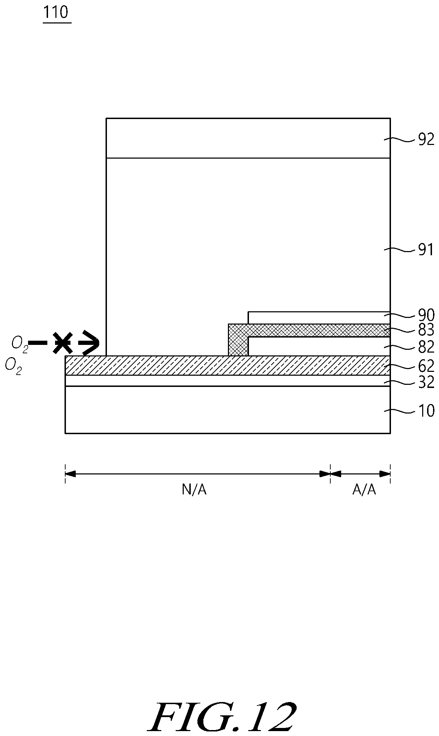

FIGs. 10 to 12 are views showing examples of cross-sections of the display panel of a display device according to embodiments of the present disclosure. FIG. 10 shows an area including light emitting elements 80, FIG. 11 shows an area including circuit elements, and FIG. 12 shows the outer part of the display panel.

With reference to FIGs. 10 to 12, the display panel of the display device according to the embodiments of the present disclosure may include a substrate 10. A circuit element layer 20 may be disposed on the substrate 10. The circuit element layer 20 may include circuit elements (e.g., a driving transistor, a sensing transistor and a storage capacitor), which constitute a subpixel, and wirings 21.

The circuit element layer 20 may include a first conductive layer that is disposed on the substrate 10. The first conductive layer may include a plurality of wirings 21. The wirings 21 may include a data line, a driving voltage line and a sensing line. The wirings 21 may be disposed between neighboring light emitting areas EA.

The first conductive layer may include a light blocking layer (not shown) and a bottom electrode 21a of the storage capacitor. The light blocking layer may be disposed to overlap the semiconductor pattern of the driving transistor to protect an oxide semiconductor element from external light. The bottom electrode 21a of the storage capacitor may be electrically connected to the gate node of the driving transistor.

The circuit element layer 20 may include a buffer layer 22. The buffer layer 22 may be disposed on the substrate 10 to cover the wirings 21, the light blocking layer and the bottom electrode 21a of the storage capacitor. The buffer layer 22 may not be disposed in a non-active area N/A. In another embodiment, the buffer layer 22 may be omitted.

Although not shown, the circuit element layer 20 may include an active layer, a gate insulating layer and a second conductive layer. The second conductive layer may include a gate electrode, a source electrode, a drain electrode and a top electrode 23 of the storage capacitor. The top electrode 23 of the storage capacitor may be disposed on the buffer layer 22 to overlap the bottom electrode 21a of the storage capacitor.

A first passivation layer 32 may be disposed on the circuit element layer 20. The first passivation layer 32 may cover the second conductive layer and the buffer layer 22 that is not covered by the second conductive layer. The first passivation layer 32 may cover the substrate 10 of the non-active area N/A that is not covered by the buffer layer 22. The first passivation layer 32 may contact the top surface of the substrate 10 in the non-active area N/A. A color filter 40 may be disposed on the first passivation layer 32.

A second passivation layer 62 may be disposed on the color filter 40 and the first passivation layer 32. The second passivation layer 62 may be disposed on the first passivation layer 32 to cover the color filter 40. The second passivation layer 62 may contact the top surface of the first passivation layer 32 in the non-active area N/A.

An overcoat layer 52 may be disposed on the second passivation layer 62. The overcoat layer 52 may have a thickness thicker than the first overcoat layer 50 or the second overcoat layer 70 described above with reference to FIGs. 3 and 4. For instance, the overcoat layer 52 may have a thickness corresponding to the sum of the thicknesses of the first overcoat layer 50 and the second overcoat layer 70 described above with reference to FIGs. 3 and 4.

A first trench T13 may be defined in the overcoat layer 52 between light emitting areas EA of neighboring subpixels. The first trench T13 may expose a side surface (a first sloped surface) 52S of the overcoat layer 52.

The first trench T13 may have a tapered shape whose dimension decreases toward the substrate 10, and the first sloped surface 52S of the overcoat layer 52 exposed by the first trench T13 may have a slope angle θ1" smaller than 90°.

A contact hole CH may be formed through the overcoat layer 52 and the first and second passivation layers 32 and 62 to expose the top electrode 23 of the storage capacitor.

A first electrode 81 is disposed on the overcoat layer 52 to expose the first trench T13. The first electrode 81 may extend to the side surface and the bottom surface of the contact hole CH to cover the side surface and the bottom surface of the contact hole CH. The first electrode 81 may be connected to the top electrode 23 of the storage capacitor that is disposed on the bottom surface of the contact hole CH.

The first trench T13 may be formed by etching the overcoat layer 52 that is not covered by the first electrode 81. In an embodiment, the first trench T13 may be self-aligned with the first electrode 81. Because the first electrode 81 is self-aligned with the first trench T13, the area of the light emitting area EA may be increased to improve aperture ratio. The opening width of the first trench T13 may have the same size as a minimum margin between adjacent subpixels. Because the first trench T13 is formed to be self-aligned with the first electrode 81, the opening width of the first trench T13 may be set to the same size as the minimum margin between neighboring subpixels.

An organic layer 82 may be disposed on the first electrode 81 and the first sloped surface 52S of the overcoat layer 52. The organic layer 82 may have a structure in which a plurality of layers are stacked. For example, the organic layer 82 may have a tandem structure. The organic layer 82 may include a first light emitting unit, a charge generation layer that is disposed on the first light emitting unit, and a second light emitting unit that is disposed on the charge generation layer. The organic layer 82 may be formed in common for a plurality of subpixels without a shadow mask.

A second electrode 83 of a light emitting element 80 may be disposed on the organic layer 82. The second electrode 83 includes a first portion 83a that overlaps the first electrode 81 and a second portion 83b that overlaps the first sloped surface 52S of the overcoat layer 52.

The first portion 83a of the second electrode 83 may constitute the light emitting element 80. The light emitting element 80 may be constituted by the first electrode 81, the first portion 83a of the second electrode 83 and the organic layer 82 disposed therebetween. By the difference between voltages applied to the first electrode 81 and the second electrode 83, light may be generated in the organic layer 82 between the first electrode 81 and the first portion 83a of the second electrode 83.

The second portion 83b of the second electrode 83 has a slope corresponding to the first slope angle θ1" of the sloped surface 52S of the overcoat layer 52. The second portion 83b of the second electrode 83 may play the role of reflecting light emitted from the organic layer 82 and extracting the light to the outside of the display panel. The second portion 83b of the second electrode 83 may play the role of increasing light extraction efficiency by reflecting light emitted from the organic layer 82 between the first electrode 81 and the first portion 83a of the second electrode 83.

A third passivation layer 90 that covers the second electrode 83 may be disposed on the second electrode 83, an encapsulation layer 91 may be disposed on the side surface and the top surface of the third passivation layer 90, and an encapsulation substrate 92 may be attached onto the third passivation layer 90 through the encapsulation layer 91.

The encapsulation layer 91 may cover an active area A/A, and may extend from the active area A/A to the non-active area N/A. Although not shown, a driving circuit, for example, at least one of a gate driving circuit and a data driving circuit, may be disposed in the non-active area N/A of the display panel, and the encapsulation layer 91 may cover the driving circuit.

The overcoat layer 52 is not disposed in the outer part of the display panel. The encapsulation layer 91 may contact the second passivation layer 62 in the outer part of the display panel. In the outer part of the display panel, the first passivation layer 32 may contact the top surface of the substrate 10, and the second passivation layer 62 may contact the top surface of the first passivation layer 32. The first and second passivation layers 32 and 62 may extend beyond the end of the encapsulation layer 91 to the edge of the display panel.

According to the embodiments of the present disclosure, because the overcoat layer 52 is not disposed in the outer part of the display panel, it is possible to suppress oxygen and/or moisture from penetrating through the overcoat layer 52 from the outside. Thus, it is possible to prevent occurrence of a defect due to penetration of oxygen and improve reliability.

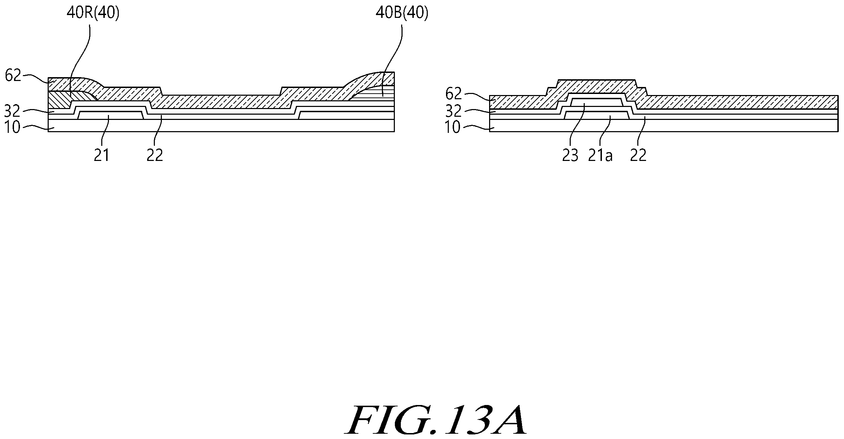

FIGs. 13A to 13E are cross-sectional views showing a method of manufacturing the display panel of a display device according to embodiments of the present disclosure, and show a method of manufacturing the display panel of the display device of FIGs. 10 to 12.

With reference to FIG. 13A, a circuit element layer is formed on a substrate 10. The circuit element layer may include wirings 21, a bottom electrode 21a of a storage capacitor, a buffer layer 22, and a top electrode 23 of the storage capacitor. Although not shown, the circuit element layer may include an active layer, a gate insulating layer, a gate electrode, a source electrode, and a drain electrode. A first passivation layer 32 is formed to cover the circuit element layer. A color filter 40 is formed on the first passivation layer 32, and a second passivation layer 62 is formed to cover the color filter 40 and the first passivation layer 32.

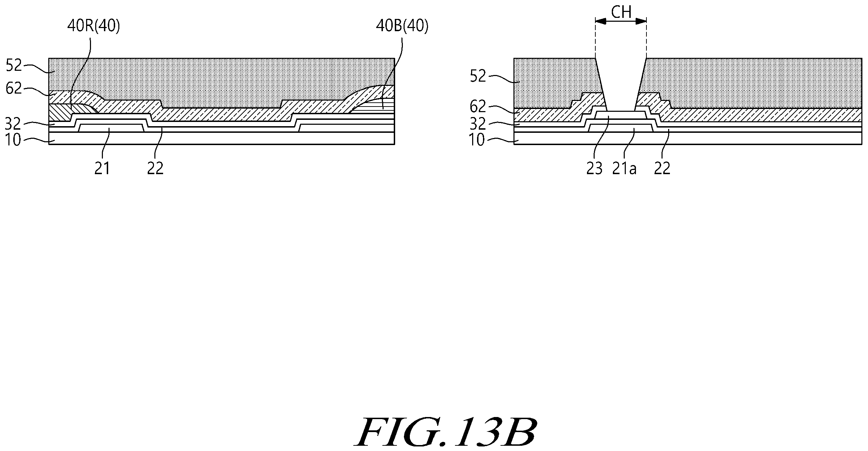

With reference to FIG. 13B, an overcoat layer 52 is formed on the second passivation layer 62, and a contact hole CH that exposes the top electrode 23 of the storage capacitor is formed in the overcoat layer 52.

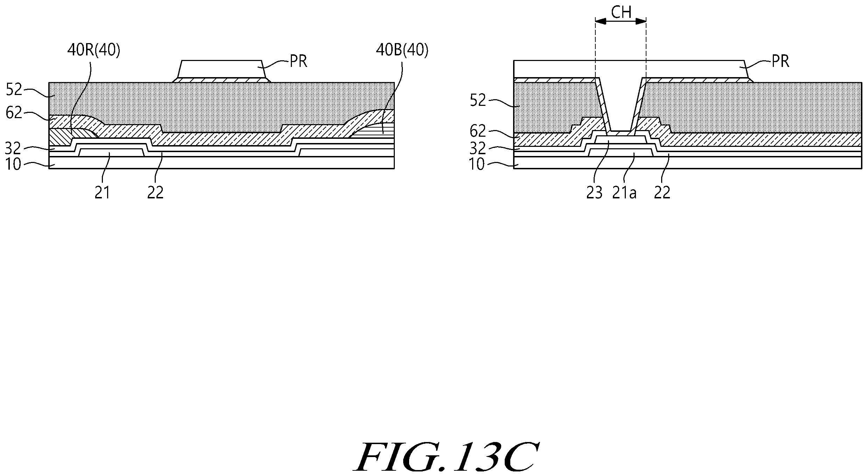

With reference to FIG. 13C, a first electrode 81 of a light emitting element is formed on the overcoat layer 52. The first electrode 81 is formed by forming a conductive layer on the overcoat layer 52, forming a mask pattern PR on the conductive layer and etching the conductive layer using the mask pattern PR as an etch mask. A wet etching process may be used as an etching process. The first electrode 81 may be disposed on a light emitting area, may extend from the light emitting area to the contact hole CH formed in a non-light emitting area, and may be connected to the top electrode 23 of the storage capacitor that is exposed through the contact hole CH.

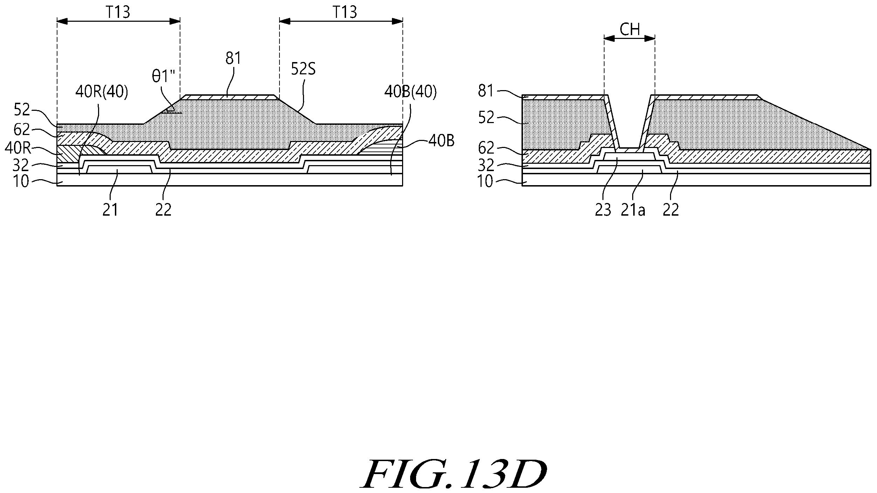

With reference to FIG. 13D, a first trench T13 is formed by etching the overcoat layer 52 using the mask pattern PR as an etch mask. A dry etching process may be used as an etching method. The first trench T13 may have a tapered shape whose width decreases toward the substrate 10. A side surface (a first sloped surface) 52S of the overcoat layer 52 may be exposed by the first trench T13. The first sloped surface 52S may have a first slope angle θ1" smaller than 90°.

Although not shown, as the overcoat layer 52 is over-etched during an etching process for forming the first trench T13, the edge of the first electrode 81 may protrude beyond the first sloped surface 52S of the overcoat layer 52. After forming the first trench T13, an additional etching process may be performed to remove the edge of the first electrode 81 that protrudes beyond the first sloped surface 52S of the overcoat layer 52.

The mask pattern PR may be formed of photoresist, and the mask pattern PR that remains after forming the first trench T13 may be removed through a strip process. In the embodiments of the present disclosure, because a separate mask pattern is not used to form the first trench T13 and the first trench T13 is formed by etching the overcoat layer 52 using the mask pattern PR used in etching the conductive layer to form the first electrode 81, the number of mask patterns is reduced compared to a case where a separate mask pattern is used to form the first trench T13.

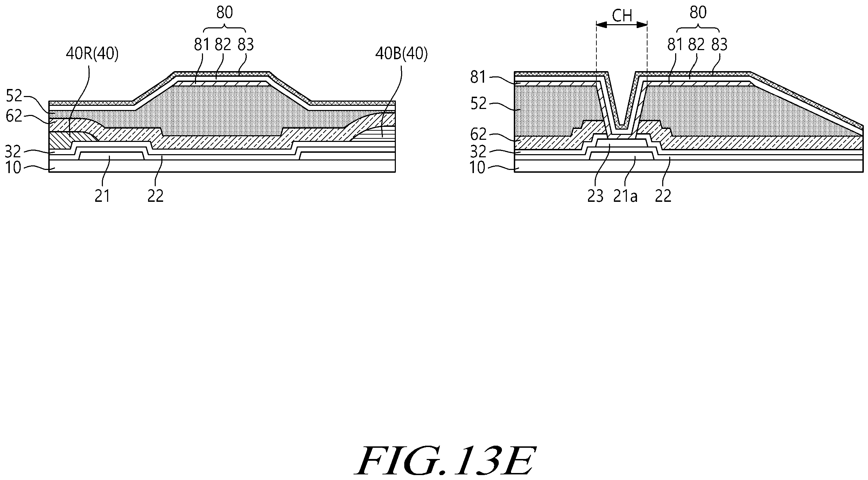

With reference to FIG. 13E, an organic layer 82 is formed on an entire surface including the first electrode 81, the first sloped surface 52S of the overcoat layer 52 and the side surface and the bottom surface of the contact hole CH, and a second electrode 83 of the light emitting element is formed on the organic layer 82. The organic layer 82 is deposited in common for subpixels without a shadow mask.

Although the second passivation layer 62 under the first trench T13 is not etched in FIGs. 10 to 12 and 13A to 13E, a second trench may be additionally formed by etching the second passivation layer 62 under the first trench T13.

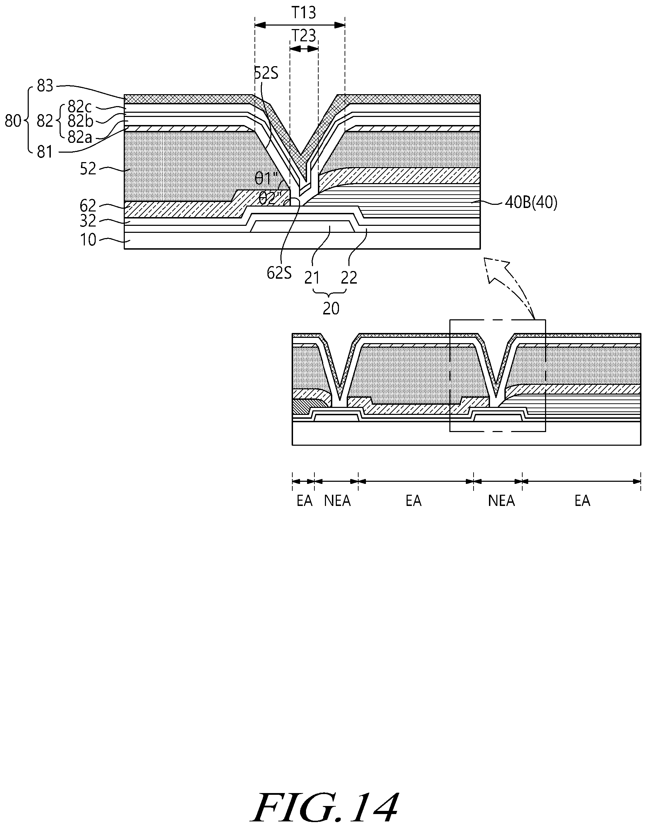

FIG. 14 is a view showing an example of a cross-section of the display panel of a display device according to embodiments of the present disclosure.

With reference to FIG. 14, as the second passivation layer 62 under the first trench T13 of the overcoat layer 52 is etched, a second trench T23 may be formed. The second trench T23 may be self-aligned with the first trench T13.

A side surface (a second sloped surface) 62S of the second passivation layer 62 may be exposed by the second trench T23. The first sloped surface 52S of the overcoat layer 52 exposed through the first trench T13 may have a first slope angle θ1". The second sloped surface 62S of the second passivation layer 62 exposed through the second trench T23 may have a second slope angle θ2" different from the first slope angle θ1". The second slope angle θ2" may be larger than the first slope angle θ1". The second sloped surface 62S may have a steeper slope than the first sloped surface 52S.

Although not shown, as the second passivation layer 62 is over-etched during a process for etching the second passivation layer 62, an undercut structure in which the edge of the second trench T23 is covered with the overcoat layer 52 may be further formed. A first electrode 81 that exposes the first and second trenches T13 and T23 is disposed on the overcoat layer 52.

An organic layer 82 may be disposed on the first electrode 81, the first sloped surface 52S of the overcoat layer 52 and the second sloped surface 62S of the second passivation layer 62. The organic layer 82 may be formed in common for a plurality of subpixels without a shadow mask.

The organic layer 82 may have a structure in which a plurality of layers are stacked. For example, the organic layer 82 may have a tandem structure. The organic layer 82 may include a first light emitting unit 82a, a charge generation layer 82b that is disposed on the first light emitting unit 82a, and a second light emitting unit 82c that is disposed on the charge generation layer 82b.

At least one of the plurality of layers included in the organic layer 82 may be cut in an area including the boundary between the first sloped surface 52S and the second sloped surface 62S. For example, the charge generation layer 82b of the organic layer 82 may be cut. The area including the boundary between the first sloped surface 52S and the second sloped surface 62S may be disposed between neighboring light emitting areas EA, and the charge generation layer 82b may be cut between the light emitting areas EA of neighboring subpixels.

According to the embodiments of the present disclosure, by disposing the second passivation layer 62 under the overcoat layer 52, forming the second trench T23 by etching the second passivation layer 62 under the first trench T13 to increase the depth of a trench under the organic layer 82, configuring the second sloped surface 62S exposed by the second trench T23 to have a steeper slope than the first sloped surface 52S exposed by the first trench T13 and additionally configuring the undercut structure in the area including the boundary between the firs sloped surface 52S and the second sloped surface 62S, the charge generation layer 82b of the organic layer 82 may be cut in the area including the boundary between the first sloped surface 52S and the second sloped surface 62S.

The thickness of the second passivation layer 62 corresponding to the depth of the second trench T23 and the second slope angle θ2" of the second sloped surface 62S exposed by the second trench T23 are determined so that the charge generation layer 82b is cut in the area including the boundary between the first sloped surface 52S and the second sloped surface 62S when depositing the charge generation layer 82b. The thickness and the second slope angle θ2" of the second passivation layer 62 may be set to values that enable cutting of the charge generation layer 82b.

A second electrode 83 of a light emitting element 80 may be disposed on the organic layer 82. The second electrode 83 includes a first portion 83a that overlaps the first electrode 81 and a second portion 83b that overlaps the first sloped surface 52S of the overcoat layer 52 and the second sloped surface 62S of the second passivation layer 62.

The first portion 83a of the second electrode 83 may constitute the light emitting element 80. The light emitting element 80 may be constituted by the first electrode 81, the first portion 83a of the second electrode 83 and the organic layer 82 disposed therebetween. By the difference between voltages applied to the first electrode 81 and the second electrode 83, light may be generated in the organic layer 82 between the first electrode 81 and the first portion 83a of the second electrode 83.

The second portion 83b of the second electrode 83 has a slope corresponding to the first sloped surface 52S of the overcoat layer 52 and the second sloped surface 62S of the second passivation layer 62. The second portion 83b of the second electrode 83 may play the role of reflecting light emitted in the organic layer 82 between the first electrode 81 and the first portion 83a of the second electrode 83 and extracting the light to the outside of the display panel. The second portion 83b of the second electrode 83 may play the role of increasing light extraction efficiency by reflecting light generated in the organic layer 82 of the light emitting area EA.

Although not shown, a third passivation layer may be disposed on the second electrode 83, an encapsulation layer may be disposed on the third passivation layer, and an encapsulation substrate may be attached onto the third passivation layer through the encapsulation layer.

The display device and display panel according to the embodiments of the present disclosure described above may be briefly described again as follows.

A display device according to embodiments of the present disclosure, including a plurality of light emitting areas corresponding to a plurality of subpixels, comprises a substrate; a circuit element layer on the substrate; a first passivation layer covering the circuit element layer; a first overcoat layer on the first passivation layer; a second passivation layer on the first overcoat layer, the second passivation layer having a first trench through the second passivation layer at a portion between two neighboring light emitting areas among the plurality of light emitting areas, wherein the second passivation layer includes a first sloped surface exposed by the first trench; a second overcoat layer on the second passivation layer, the second overcoat layer having a second trench defined by a second sloped surface of the second overcoat layer adjacent to the first trench, and the second trench exposing the first trench; a first electrode on the second overcoat layer, and exposing the first and second trenches; an organic layer on the first electrode, the first sloped surface, and the second sloped surface; and a second electrode on the organic layer.

According to one or more embodiments of the present disclosure, the first sloped surface and the second sloped surface may have different slope angles.

According to one or more embodiments of the present disclosure, the first sloped surface may have a larger slope angle than the second sloped surface.

According to one or more embodiments of the present disclosure, the organic layer may include a plurality of layers, and at least one among the plurality of layers may be separated between the two neighboring light emitting areas.

According to one or more embodiments of the present disclosure, the organic layer may include a first light emitting unit, a charge generation layer on the first light emitting unit and a second light emitting unit on the charge generation layer, and the charge generation layer may be separated at an area including a boundary between the first sloped surface and the second sloped surface.

According to one or more embodiments of the present disclosure, the second trench may be self-aligned with the first electrode.

According to one or more embodiments of the present disclosure, the first trench may be self-aligned with the second trench.

According to one or more embodiments of the present disclosure, the display device may further include an undercut structure in which an edge of the first trench is covered with the second overcoat layer.

According to one or more embodiments of the present disclosure, the display device may further include a color filter layer on the first passivation layer, and the first overcoat layer may be disposed on the color filter layer.

A display device according to embodiments of the present disclosure, including a plurality of light emitting areas corresponding to a plurality of subpixels, comprises a substrate; a circuit element layer on the substrate; a first passivation layer on the circuit element layer; a first overcoat layer on the first passivation layer; a second overcoat layer on the first overcoat layer, the second overcoat layer having a first trench through the second overcoat layer at a portion between two neighboring light emitting areas among the plurality of light emitting areas, wherein the second overcoat layer includes a first sloped surface exposed by the first trench; a second passivation layer on the second overcoat layer, the second passivation layer having a second trench defined by a second sloped surface of the second passivation layer adjacent to the first trench, and the second trench exposing the first trench; a first electrode on the second passivation layer, and exposing the first and second trenches; an organic layer on the first electrode, the first sloped surface, and the second sloped surface; and a second electrode on the organic layer.

According to one or more embodiments of the present disclosure, the display device may further include an undercut structure in which an edge of the first trench is covered with the second passivation layer.

According to one or more embodiments of the present disclosure, the organic layer may include a plurality of layers, and at least one among the plurality of layers may be separated between the two neighboring light emitting areas.

According to t one or more he embodiments of the present disclosure, the organic layer may include a charge generation layer that is separated at an area including a boundary between the first sloped surface and the second sloped surface.

According to one or more embodiments of the present disclosure, the first sloped surface and the second sloped surface have different slope angles.

According to one or more embodiments of the present disclosure, the second sloped surface may have a larger slope angle than the first sloped surface.

A display device according to embodiments of the present disclosure, including a plurality of light emitting areas corresponding to a plurality of subpixels, comprises a substrate; a circuit element layer on the substrate; a first passivation layer on the circuit element layer; a color filter layer on the first passivation layer; a second passivation layer covering the color filter layer; an overcoat layer on the second passivation layer, the overcoat layer having a first trench with a first sloped surface of the overcoat layer at a portion between two neighboring light emitting areas among the plurality of light emitting areas; a first electrode on the overcoat layer and exposing the first trench; an organic layer on the first electrode and the first sloped surface; and a second electrode on the organic layer.

According to one or more embodiments of the present disclosure, the first trench may be self-aligned with the first electrode.

According to one or more embodiments of the present disclosure, the display device may further include a second trench defined in the second passivation layer under the first trench.

According to one or more embodiments of the present disclosure, the second trench may be self-aligned with the first trench.

According to one or more embodiments of the present disclosure, a second sloped surface of the second passivation layer exposed through the second trench may have a different slope angle from the first sloped surface.

According to one or more embodiments of the present disclosure, the second sloped surface may have a larger slope angle than the first sloped surface.

According to one or more embodiments of the present disclosure, the display device may further include an undercut structure in which an edge of the second trench is covered with the overcoat layer.

According to one or more embodiments of the present disclosure, the organic layer may include a charge generation layer that is separated at an area including a boundary between the first sloped surface and the second sloped surface.

According to one or more embodiments, the display device further comprises: a display panel including an active area comprising the plurality of light emitting areas corresponding to the plurality of subpixels, and a non-active area surrounding the active area, wherein the display panel comprises: the substrate; the circuit element layer; the first passivation layer; the color filter layer; the second passivation layer; the overcoat layer; the first electrode; the organic layer; and the second electrode.

According to one or more embodiments, the display device further comprises: a third passivation layer covering the second electrode; and an encapsulation layer on the active area and the non-active area, and covering the third passivation layer, wherein the encapsulation layer contacts the second passivation layer in an outer part of the display panel.

According to one or more embodiments, the first passivation layer and the second passivation layer extend beyond an end of the encapsulation layer to an edge of the display panel.

According to one or more embodiments, the first passivation layer contacts a top surface of the substrate in an outer part of the display panel, and the second passivation layer contacts a top surface of the first passivation layer.

According to one or more embodiments, the display device further comprises: a driving circuit in the non-active area of the display panel, wherein the encapsulation layer covers the driving circuit.

According to one or more embodiments, the overcoat layer is absent in the outer part of the display panel.

A display device according to embodiments of the present disclosure includes a display panel including an active area having a plurality of light emitting areas corresponding to a plurality of subpixels and a non-active area surrounding the active area; the display panel including: a substrate; a circuit element layer on the substrate; a first passivation layer on the circuit element layer; a color filter layer on the first passivation layer; a second passivation layer covering the color filter layer; an overcoat layer on the second passivation layer, the overcoat layer having a first trench with a first sloped surface of the overcoat layer at a portion between two neighboring light emitting areas among the plurality of light emitting areas; a first electrode on the overcoat layer and exposing the first trench; an organic layer on the first electrode and the first sloped surface; and a second electrode on the organic layer.

According to one or more embodiments of the present disclosure, the display device may further include a third passivation layer covering the second electrode, and an encapsulation layer on the active area and the non-active area, and covering the third passivation layer, and the encapsulation layer may contact the second passivation layer in an outer part of the display panel.

According to one or more embodiments of the present disclosure, the first passivation layer and the second passivation layer may extend beyond an end of the encapsulation layer to an edge of the display panel.

According to one or more embodiments of the present disclosure, the first passivation layer may contact a top surface of the substrate in an outer part of the display panel, and the second passivation layer may contact a top surface of the first passivation layer.

According to one or more embodiments of the present disclosure, the display device may further include a driving circuit in the non-active area of the display panel, and the encapsulation layer may cover the driving circuit.

According to one or more embodiments of the present disclosure, the overcoat layer may be absent in the outer part of the display panel.

Through such a structure, according to the embodiments of the present disclosure, it is possible to provide a display device that can improve light extraction efficiency and suppress side leakage current.

According to the embodiments of the present disclosure, it is possible to provide a display device that can suppress side leakage current to minimize light emission of an unintended subpixel to improve color gamut and that can minimize the visual recognition of spots or color abnormalities when displaying an image of a low grayscale, to improve display quality.

According to the embodiments of the present disclosure, it is possible to provide a display device that can improve light extraction efficiency to increase the amount of light emitted from the display device so as to increase luminance, can emit a sufficient amount of light at a low voltage to reduce power consumption, and can improve light efficiency to increase a viewing angle and luminance so as to provide a wide viewing angle.

According to the embodiments of the present disclosure, it is possible to provide a display device that can suppress penetration of oxygen from the outside to prevent defects due to oxygen penetration and improve reliability.

According to the embodiments of the present disclosure, it is possible to provide a display device that can be manufactured at low cost by reducing the number of masks to be used.

It will be apparent to those skilled in the art that various modifications and variations can be made in the display device of the present disclosure without departing from the technical idea or scope of the disclosure. Thus, it is intended that the present disclosure cover the modifications and variations of this disclosure provided they come within the scope of the appended claims.

## Claims

1. A display device (100) comprising a plurality of light emitting areas (EA) corresponding to a plurality of subpixels (SP), the display device (100) comprising:
a substrate (10);
a circuit element layer (20) on the substrate (10);
a first passivation layer (30) covering the circuit element layer (20);
a first overcoat layer (50) on the first passivation layer (30);
a second passivation layer (60) on the first overcoat layer (50), the second passivation layer (60) having a first trench (T11) through the second passivation layer (60) at a portion between two neighboring light emitting areas (EA) among the plurality of light emitting areas (EA), wherein the second passivation layer (60) includes a first sloped surface (60S) exposed by the first trench (T11);
a second overcoat layer (70) on the second passivation layer (60), the second overcoat layer (70) having a second trench (T21) defined by a second sloped surface (70S) of the second overcoat layer (70) adjacent to the first trench (T11), and the second trench (T21) exposing the first trench (T11);
a first electrode (81) on the second overcoat layer (70), and exposing the first and second trenches (T11, T21);
an organic layer (82) on the first electrode (81), the first sloped surface (60S), and the second sloped surface (70S); and
a second electrode (83) on the organic layer (82).

2. The display device (100) of claim 1, wherein the first sloped surface (60S) and the second sloped surface (70S) have different slope angles, and/or wherein the first sloped surface (60S) has a larger slope angle than the second sloped surface (70S).

3. The display device (100) of claim 1 or 2, wherein the organic layer (82) includes a plurality of layers (82a, 82b, 82c), and
wherein at least one among the plurality of layers (82a, 82b, 82c) is separated between the two neighboring light emitting areas (EA).

4. The display device (100) of any of claims 1 to 3, wherein the organic layer (82) includes a first light emitting unit (82a), a charge generation layer (82b) on the first light emitting unit (82a), and a second light emitting unit (82c) on the charge generation layer (82b), and
wherein the charge generation layer (82b) is separated at an area including a boundary between the first sloped surface (60S) and the second sloped surface (70S).

5. The display device (100) of any of claims 1 to 4, wherein the second trench (T21) is self-aligned with the first electrode (81), and/or wherein the first trench (T11) is self-aligned with the second trench (T21).

6. The display device (100) of any of claims 1 to 5, further comprising an undercut structure in which an edge of the first trench (T1 1) is covered with the second overcoat layer (70), and/or further comprising a color filter layer (40) on the first passivation layer (30), wherein the first overcoat layer (50) is on the color filter layer (40).

7. A display device (100) comprising a plurality of light emitting areas (EA) corresponding to a plurality of subpixels (SP), the display device comprising:
a substrate (10);
a circuit element layer (20) on the substrate (10);
a first passivation layer (31) on the circuit element layer (20);
a first overcoat layer (51) on the first passivation layer (31);
a second overcoat layer (71) on the first overcoat layer (51), the second overcoat layer (71) having a first trench (T12) through the second overcoat layer (71) at a portion between two neighboring light emitting areas (EA) among the plurality of light emitting areas (EA), wherein the second overcoat layer (71) includes a first sloped surface (71S) exposed by the first trench (T12);
a second passivation layer (61) on the second overcoat layer (71), the second passivation layer (61) having a second trench (T22) defined by a second sloped surface (61S) of the second passivation layer (61) adjacent to the first trench (T12), and the second trench (T22) exposing the first trench (T12);
a first electrode (81) on the second passivation layer (61), and exposing the first and second trenches (T12, T22);
an organic layer (82) on the first electrode (81), the first sloped surface (61S), and the second sloped surface; and
a second electrode (83) on the organic layer (82).

8. The display device (100) of claim 7, further comprising an undercut structure (UDC) in which an edge of the first trench (T12) is covered with the second passivation layer (61).

9. The display device (100) of claim 7 or 8, wherein the organic layer (82) includes a plurality of layers (82a, 82b, 82c), and
wherein at least one among the plurality of layers (82a, 82b, 82c) is separated between the two neighboring light emitting areas (EA).

10. The display device (100) of any of claims 7 to 9, wherein the organic layer (82) includes a charge generation layer (82b) that is separated at an area including a boundary between the first sloped surface (71S) and the second sloped surface (61S).

11. The display device (100) of any of claims 7 to 10, wherein the first sloped surface (71S) and the second sloped surface (61S) have different slope angles, and/or wherein the second sloped surface (61S) has a larger slope angle than the first sloped surface (71S).

12. A display device (100) comprising a plurality of light emitting areas (EA) corresponding to a plurality of subpixels (SP), the display device (100) comprising:
a substrate (10);
a circuit element layer (20) on the substrate (10);
a first passivation layer (32) on the circuit element layer (20);
a color filter layer (40) on the first passivation layer (32);
a second passivation layer (62) covering the color filter layer (40);
an overcoat layer (52) on the second passivation layer (62), the overcoat layer (52) having a first trench (T13) with a first sloped surface (52S) of the overcoat layer (52) at a portion between two neighboring light emitting areas (EA) among the plurality of light emitting areas (EA);
a first electrode (81) on the overcoat layer (52) and exposing the first trench (T13);
an organic layer (82) on the first electrode (81) and the first sloped surface (52S); and
a second electrode (83) on the organic layer (82).

13. The display device (100) of claim 12, wherein the first trench (T13) is self-aligned with the first electrode (81).

14. The display device (100) of claim 12 or 13, further comprising a second trench (T23) defined in the second passivation layer (62) under the first trench (T13),
wherein, preferably, the second trench (T23) is self-aligned with the first trench (T13).

15. The display device (100) of claim 14, wherein a second sloped surface (62S) of the second passivation layer (62) exposed through the second trench (T23) has a different slope angle from the first sloped surface (52S),
wherein, preferably, the second sloped surface (62S) has a larger slope angle than the first sloped surface (52S).

16. The display device (100) of claim 15, further comprising an undercut structure in which an edge of the second trench (T23) is covered with the overcoat layer (52).

17. The display device (100) of claim 15 or 16, wherein the organic layer (82) includes a charge generation layer (82b) which is separated at an area including a boundary between the first sloped surface (52S) and the second sloped surface (62S).

18. The display device (100) of any of claims 12 to 17, further comprising:
a display panel (110) including an active area (A/A) comprising the plurality of light emitting areas (EA) corresponding to the plurality of subpixels (SP), and a non-active area (N/A) surrounding the active area (A/A),
wherein the display panel (110) comprises:
the substrate (10);
the circuit element layer (20);
the first passivation layer (32);
the color filter layer (40);
the second passivation layer (62);
the overcoat layer (52) ;
the first electrode (81);
the organic layer (82); and
the second electrode (83).

19. The display device (100) of claim 18, further comprising:
a third passivation layer (90) covering the second electrode (83); and
an encapsulation layer (91) on the active area (A/A) and the non-active area (N/A), and covering the third passivation layer (90),
wherein the encapsulation layer (91) contacts the second passivation layer (62) in an outer part of the display panel (110).

20. The display device (100) of claim 19, wherein the first passivation layer (32) and the second passivation layer (62) extend beyond an end of the encapsulation layer (91) to an edge of the display panel (110).

21. The display device (100) of any of claims 18 to 20, wherein the first passivation layer (32) contacts a top surface of the substrate (10) in an outer part of the display panel (110), and the second passivation layer (62) contacts a top surface of the first passivation layer (32).

22. The display device (100) of claim 19 or 20, further comprising a driving circuit (120, 130) in the non-active area (N/A) of the display panel (110), wherein the encapsulation layer (91) covers the driving circuit (120, 130); and/or
wherein the overcoat layer (52) is absent in the outer part of the display panel (110).
